# EUROPEAN PATENT APPLICATION

(11) **EP 4 439 179 A1**
(43) Date of publication of application: **02.10.2024**
(21) Application number: 22837673.7
(22) Date of filing: 05.07.2022
(51) Int. Cl.: G03F 7/30, B41C 1/00, B41M 1/04, B41N 1/00, B41N 3/06, G03F 7/00

(54) **WASHING-OUT DEVICE AND WASHING-OUT METHOD**

(30) Priority: 09.07.2021 JP 2021114295
(71) Applicant: FUJIFILM Corporation, Tokyo 106-8620 (JP)
(72) Inventor: MOGI, Fumio, Haibara-gun, Shizuoka 421-0396 (JP); HASHIGAYA, Manabu, Haibara-gun, Shizuoka 421-0396 (JP); WATANABE, Toshihiro, Haibara-gun, Shizuoka 421-0396 (JP); IKEYAMA, Yusuke, Haibara-gun, Shizuoka 421-0396 (JP)
(74) Representative: HGF
(86) International application number: PCT/JP2022/026700
(87) International publication number: WO 2023/282259

(57) **Abstract**

There are provided a washout processor and a washing method that prevent solid contents from being attached to a developed flexographic printing plate precursor again. A washout processor that develops an imagewise exposed flexographic printing plate precursor using a washing solution includes a developing tank that is filled with the washing solution, a development unit that performs the development by removing a non-exposed portion of the flexographic printing plate precursor using the washing solution in the developing tank, and a flow creation unit that flows the washing solution in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

## Description

### BACKGROUND OF THE INVENTION

### 1. Field of the Invention

The present invention relates to a washout processor and a washing method in which an imagewise exposed flexographic printing plate precursor is developed using a washing solution.

### 2. Description of the Related Art

Various types of methods are known as developing methods for a printing plate formed of a photosensitive resin plate. For example, in a developing method of performing development using an aqueous developer of which a main component is water, development is performed by applying the aqueous developer to an imagewise exposed photosensitive resin plate with a brush or the like and washing out an uncured resin or the like, which is a non-exposed portion.

For example, JP6044072B describes a method of developing a water-dispersed type photosensitive flexographic printing plate using a brush immersed in a developer in a developing tank with a brush tip facing an upward direction, that is a circulation type developer flowing method of flowing the developer to a developer discharge port of a side surface on an opposite side of a developer supply port provided in one side surface of the developing tank, and that is a developing method for a photosensitive flexographic printing plate of flowing the developer into a developing brush up and down through a method in which the developer flowed in from the developer supply port simultaneously flows up and down with respect to the developing brush and the supplied developer is applied to a brush support substrate or a method in which supply ports are provided at positions corresponding up and down with respect to the developing brush. The photosensitive flexographic printing plate of JP6044072B corresponds to the photosensitive resin plate.

### SUMMARY OF THE INVENTION

In the developing method for a photosensitive flexographic printing plate of JP6044072B, it is attempted to suppress sedimentation of solid contents or a photosensitive resin aggregate of a non-exposed portion on a developing brush edge part or a treatment tank bottom portion by providing a flow such that the developer flows in up and down with respect to the brush from the one side surface of a treatment tank to the side surface on the opposite side.

However, in the developing method of JP6044072B, in a case of raising the photosensitive flexographic printing plate, on which development treatment is completed, from the developer, the solid contents dispersed in the developer are attached to the photosensitive flexographic printing plate again. The again attached solid contents are difficult to be peeled off, and the quality of the printing plate deteriorates. For this reason, it is desirable that the solid contents are not attached again to the photosensitive flexographic printing plate after development.

An object of the present invention is to provide a washout processor and a washing method that prevent solid contents from being attached to a developed flexographic printing plate precursor again.

According to an aspect of the present invention, in order to achieve the object described above, there is provided a washout processor that develops an imagewise exposed flexographic printing plate precursor using a washing solution, the washout processor including a developing tank that is filled with the washing solution, a development unit that performs the development by removing a non-exposed portion of the flexographic printing plate precursor using the washing solution in the developing tank, and a flow creation unit that flows the washing solution in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

According to another aspect of the present invention, there is provided a washout processor that develops an imagewise exposed flexographic printing plate precursor using a washing solution, the washout processor including a developing tank that is filled with the washing solution, a development unit that performs the development by removing a non-exposed portion of the flexographic printing plate precursor using the washing solution in the developing tank, a transporting unit that carries the imagewise exposed flexographic printing plate precursor into the washing solution of the developing tank and that carries out the flexographic printing plate precursor after being developed by the development unit, a rinsing unit that supplies a rinsing liquid to the developed flexographic printing plate precursor carried out from the development unit by the transporting unit, and a flow creation unit that flows the washing solution in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

It is preferable that the flow creation unit flows the washing solution in the second region in the intersecting direction to cross the width of the flexographic printing plate precursor with respect to the traveling direction of the flexographic printing plate precursor.

It is preferable that the intersecting direction to cross the width of the flexographic printing plate precursor with respect to the traveling direction of the flexographic printing plate precursor is a direction orthogonal to the traveling direction of the flexographic printing plate precursor.

The first region and the second region may be the same region.

It is preferable that the flow creation unit flows the washing solution at a liquid flow rate of 50 cm/sec or more.

It is preferable that the developing tank has a first tank portion and a second tank portion with which the washing solution communicates, the flexographic printing plate precursor is carried in from the first tank portion, and the flexographic printing plate precursor after development is carried out from the second tank portion. It is preferable that the first region is in the first tank portion, and the second region is in the second tank portion.

It is preferable to have a filter that removes the non-exposed portion generated by the development from a collected washing solution and a supply unit that supplies a washing solution from which the non-exposed portion is removed by the filter to the developing tank.

It is preferable that a restricting member that restricts a flow passage of the washing solution flowing in the intersecting direction to cross the width of the flexographic printing plate precursor is provided in at least one of the first region or the second region.

It is preferable that a temperature adjusting device that adjusts a temperature of the washing solution is included. It is preferable that the temperature adjusting device has a heater. It is preferable that the heater includes a pipe, a block in which a part of the pipe is buried, and a heating heater provided in the block, and the block is formed of a metal material.

It is preferable that the heater further has a pump that causes the washing solution to pass through an inside of the pipe in the block at a liquid flow rate of 100 cm/sec or more.

According to still another aspect of the present invention, there is provided a washing method of developing an imagewise exposed flexographic printing plate precursor using a washing solution, the washing method including a developing step of performing the development by removing a non-exposed portion of the flexographic printing plate precursor using the washing solution in a developing tank filled with the washing solution, in which the washing solution is flowed in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

According to still another aspect of the present invention, there is provided a washing method of developing an imagewise exposed flexographic printing plate precursor using a washing solution, the washing method including a developing step of performing the development by removing a non-exposed portion of the flexographic printing plate precursor using the washing solution in a developing tank filled with the washing solution and a rinsing step of supplying a rinsing liquid to the developed flexographic printing plate precursor carried out from the developing tank, in which the washing solution is flowed in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

It is preferable that the washing solution is flowed in the second region in the intersecting direction to cross the width of the flexographic printing plate precursor with respect to the traveling direction of the flexographic printing plate precursor.

It is preferable that the intersecting direction to cross the width of the flexographic printing plate precursor with respect to the traveling direction of the flexographic printing plate precursor is a direction orthogonal to the traveling direction of the flexographic printing plate precursor.

The first region and the second region may be the same region.

It is preferable that the washing solution is flowed at a liquid flow rate of 50 cm/sec or more.

It is preferable that the developing tank has a first tank portion and a second tank portion with which the washing solution communicates, the flexographic printing plate precursor is carried in from the first tank portion, and the flexographic printing plate precursor after development is carried out from the second tank portion. It is preferable that the first region is in the first tank portion, and the second region is in the second tank portion.

It is preferable that after the non-exposed portion generated by the development is removed from a collected washing solution, the washing solution from which the non-exposed portion is removed by a filter is supplied to the developing tank.

It is preferable that a temperature of the washing solution is adjusted. It is preferable that a heater is used in adjusting the temperature of the washing solution. It is preferable that the heater includes a pipe, a block in which a part of the pipe is buried, and a heating heater provided in the block, and the block is formed of a metal material.

It is preferable that the washing solution is passed through an inside of the pipe in the block at a liquid flow rate of 100 cm/sec or more.

With the present invention, the washout processor and the washing method that prevent solid contents from being attached to the developed flexographic printing plate precursor again can be provided.

### BRIEF DESCRIPTION OF THE DRAWINGS

Fig. 1 is a schematic side view showing a first example of a washout processor according to an embodiment of the present invention.
Fig. 2 is a schematic plan view showing the first example of the washout processor according to the embodiment of the present invention.
Fig. 3 is a schematic view showing carrying-out of a flexographic printing plate precursor of the first example of the washout processor according to the embodiment of the present invention.
Fig. 4 is a schematic side view showing a second example of the washout processor according to the embodiment of the present invention.
Fig. 5 is a schematic plan view showing the second example of the washout processor according to the embodiment of the present invention.
Fig. 6 is a schematic side view showing a third example of the washout processor according to the embodiment of the present invention.
Fig. 7 is a schematic perspective view showing main portions of the third example of the washout processor according to the embodiment of the present invention.
Fig. 8 is a schematic plan view showing the main portions of the third example of the washout processor according to the embodiment of the present invention.
Fig. 9 is a schematic plan view showing a transporting form of the flexographic printing plate precursor according to the embodiment of the present invention.
Fig. 10 is a schematic view showing an example of a leading end leader used in transporting the flexographic printing plate precursor according to the embodiment of the present invention.
Fig. 11 is a schematic view showing an example of a trailing end of a leader mechanism portion used in transporting the flexographic printing plate precursor according to the embodiment of the present invention.
Fig. 12 is a schematic plan view showing another example of the transporting form of the flexographic printing plate precursor according to the embodiment of the present invention.
Fig. 13 is a schematic plan view showing the third example of the washout processor according to the embodiment of the present invention.
Fig. 14 is a schematic view showing an example of a configuration of a developing tank of the third example of the washout processor according to the embodiment of the present invention.
Fig. 15 is a schematic side view showing a fourth example of the washout processor according to the embodiment of the present invention.
Fig. 16 is a schematic plan view showing the fourth example of the washout processor according to the embodiment of the present invention.
Fig. 17 is a schematic view showing a first example of a rinsing unit of the third example of the washout processor according to the embodiment of the present invention.
Fig. 18 is a schematic view showing a second example of the rinsing unit of the third example of the washout processor according to the embodiment of the present invention.
Fig. 19 is a schematic perspective view showing an example of a heater used in the washout processor according to the embodiment of the present invention.

### DESCRIPTION OF THE PREFERRED EMBODIMENTS

Hereinafter, a washout processor and a washing method according to an embodiment of the present invention will be described in detail based on the suitable embodiment shown in the accompanying drawings.

The drawings to be described below are exemplary for describing the present invention, and the present invention is not limited to the drawings shown below.

In the following, "to" indicating a numerical range includes numerical values described on both sides. For example, in a case where ε is a numerical value α to a numerical value β, the range ε is a range including the numerical value α and the numerical value β, which is expressed by a mathematical symbol α ≤ ε ≤ β.

In addition, "orthogonal" and a specific angle include a range of errors generally acceptable in the corresponding technical field unless particularly stated otherwise. Further, a numerical value or the like includes a range of errors generally acceptable in the corresponding technical field unless particularly stated otherwise.

### (First Example of Washout Processor)

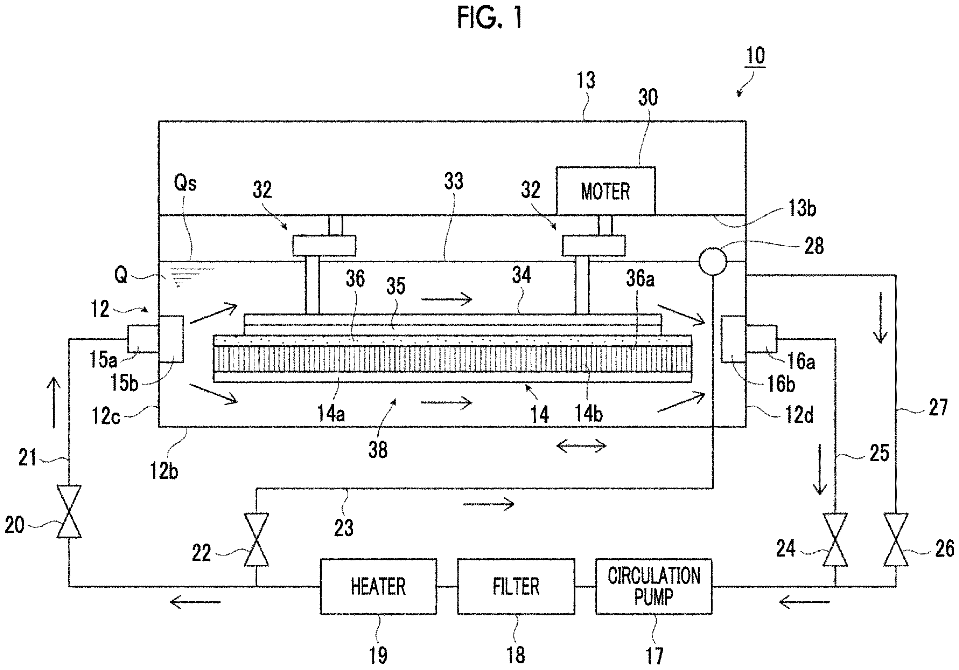

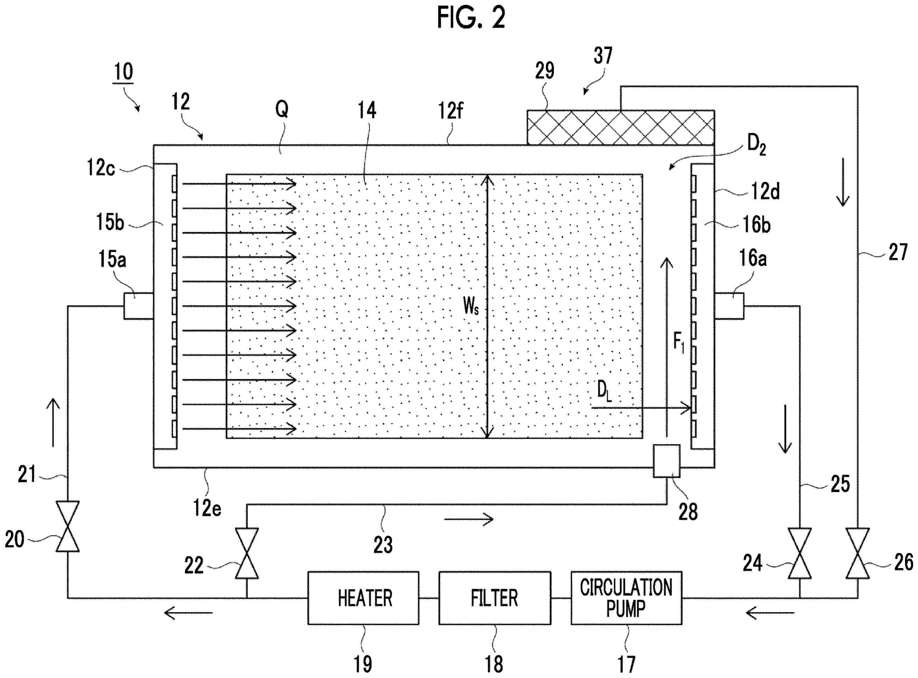

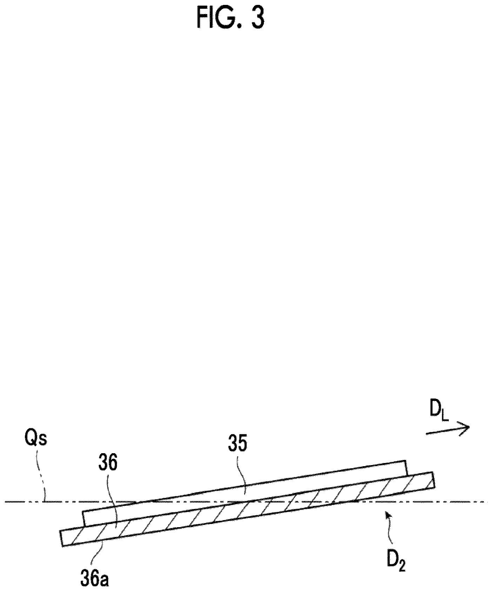

Fig. 1 is a schematic side view showing a first example of the washout processor according to the embodiment of the present invention. Fig. 2 is a schematic plan view showing the first example of the washout processor according to the embodiment of the present invention. Fig. 3 is a schematic view showing carrying-out of a flexographic printing plate precursor of the first example of the washout processor according to the embodiment of the present invention. A washout processor 10 shown in Fig. 1 has a configuration called a clamshell type. In Fig. 2, a lid 13 is not shown. In addition, a control unit is not shown in Figs. 1 and 2, but each unit of the washout processor 10 is controlled by the control unit.

The washout processor 10 has a developing tank 12 and the lid 13 of the developing tank 12. The lid 13 is openable and closable with respect to the developing tank 12, and for example, the developing tank 12 and the lid 13 are connected to each other using a hinge. In a state where the lid 13 is closed as shown in Fig. 1, a back surface 13b of the lid 13 faces a liquid level Qs of a washing solution Q in the developing tank 12.

A brush 14 is disposed on a bottom surface 12b side in the developing tank 12. In a state where the brush 14 is fixed, development is performed on a flexographic printing plate precursor 36. The brush 14 is obtained, for example, by bundling bristles 14b perpendicular to a quadrangular substrate 14a in plan view. The substrate 14a is fixed into the developing tank 12 by a fixing unit (not shown). The shape of the substrate 14a is the shape of the brush 14. The shape of the substrate 14a is not limited to a quadrangle in plan view.

In addition, a material for the bristles of the brush 14 is not particularly limited, and for example, a known material used for the development of the flexographic printing plate precursor 36, such as nylon 6,6, nylon 610, nylon 612, polybutylene terephthalate (PBT), and polyethylene terephthalate (PET), can be used as appropriate.

A supply port 15a is provided in a side surface 12c of the developing tank 12. Ablowout port 15b is provided at the supply port 15a in the developing tank 12. A first valve 20 is provided at the supply port 15a via a pipe 21.

An output port 16a is provided in a side surface 12d facing the side surface 12c of the developing tank 12. A suction port 16b is provided at the output port 16a in the developing tank 12. A third valve 24 is provided at the output port 16a via a pipe 25.

A circulation pump 17, a filter 18, and a heater 19 are provided from a third valve 24 side between the first valve 20 and the third valve 24.

The washing solution Q in the developing tank 12 is taken in from the output port 16a via the suction port 16b by the circulation pump 17, goes via the filter 18 and the heater 19, and is supplied into the developing tank 12 from the supply port 15a via the blowout port 15b as a regenerated washing solution as will be described later. The circulation pump 17 is a supply unit that supplies the washing solution Q from which a non-exposed portion is removed by the filter 18 to the developing tank 12, and a pump that transfers a known liquid is usable as appropriate. The circulation pump 17 corresponds to the supply unit that supplies the washing solution Q from which the non-exposed portion is removed to the developing tank 12.

The filter 18 is a filter that removes a non-exposed portion generated by development from the washing solution Q and removes solid contents (not shown) in the washing solution after the development. The filter 18 can reduce the concentration of the solid contents. With the filter 18, a regenerated washing solution is obtained from the washing solution after the development, that is, a fatiqued developer. For this reason, the regenerated washing solution is supplied to the developing tank 12 through the filter 18.

The filter 18 is not particularly limited insofar as solid contents (not shown) in a washing solution after development can be separated out and is determined as appropriate according to the size of solid contents to be separated out. For example, a ceramic filter is used. It is preferable that the filter 18 can separate out, for example, a solid content having a particle diameter of 1 µm or less.

The regenerated washing solution is a solution obtained by reducing the concentration of the solid contents from the washing solution after development, that is, the fatiqued developer with the filter 18 or a filter 29 to be described later.

The heater 19 adjusts the temperature of the washing solution Q supplied into the developing tank 12 to a determined temperature, for example, a range of 40°C to 50°C. A liquid temperature of the washing solution Q is adjusted by the heater 19. The configuration of the heater 19 is not particularly limited, and a known configuration is usable as appropriate.

In addition, a temperature adjusting device (not shown) that has the heater 19 which adjusts the liquid temperature of the washing solution Q may be included, or the temperature adjusting device may be the heater 19.

As shown in Fig. 2, a liquid feeding port 28 is provided in a side surface 12e of the developing tank 12. A second valve 22 is provided at the liquid feeding port 28 via a pipe 23. The second valve 22 is connected between the heater 19 and the first valve 20. The washing solution Q after development is supplied to the liquid feeding port 28 via the filter 18 and the heater 19.

At a side surface 12f facing the side surface 12e, the filter 29 is provided on an overflow port facing the liquid feeding port 28. A port from which a liquid overflowing from the developing tank 12 due to inflow of the washing solution Q to the developing tank 12 is discharged is referred to as an overflow port.

The filter 29 consists of a nonwoven fabric made of a polyolefin-based resin, is spread in the overflow port, and allows an overflowing liquid caused by the inflow of the washing solution Q to the developing tank 12 to pass therethrough. The filter 29 removes a non-exposed portion of the flexographic printing plate precursor 36 which is generated by development from the washing solution Q. A resin component of the flexographic printing plate precursor 36, which is the non-exposed portion, has a low specific gravity and thereby aggregates or floats on the liquid level Qs while diffusing in the washing solution Q. Relatively large floating substances floating on the liquid level Qs are discharged from the overflow port with the inflow of the washing solution Q and are captured by the filter 29.

A fourth valve 26 is provided at the overflow port comprising the filter 29 via a pipe 27. The washing solution Q flows from the liquid feeding port 28 in the developing tank 12 to form a flow of the washing solution Q from the liquid feeding port 28 toward the filter 29.

A region between the liquid feeding port 28 and the filter 29 is a second region D₂ where the flexographic printing plate precursor 36 is carried out.

In the second region D₂, as a flow of the washing solution Q in a direction F₁ from the liquid feeding port 28 toward the filter 29 is formed, a non-exposed portion (not shown) removed due to development is prevented from being attached to the developed flexographic printing plate precursor 36. That is, solid contents are prevented from being attached to the developed flexographic printing plate precursor 36.

The direction F₁ from the liquid feeding port 28 toward the filter 29 is not particularly limited insofar as the direction F₁ is an intersecting direction to cross a width Ws of the flexographic printing plate precursor 36, but is preferably a direction orthogonal to a traveling direction D_{L} of the flexographic printing plate precursor 36.

In a case where the term "orthogonal" is defined as 90°, the orthogonal direction described above is allowed to be in a range of 80° to 100°.

In the example shown in Fig. 2, the filter 29 that efficiently removes relatively large floating substances floating on the liquid level Qs and that can reduce a load on the filter 18 is included at the overflow port, but an effect of preventing solid contents from being attached to the developed flexographic printing plate precursor 36 is not impaired even without the filter 29.

A flow creation unit 37 that flows the washing solution Q in the intersecting direction to cross the width Ws of the flexographic printing plate precursor 36 is composed of the circulation pump 17, the filter 18, the heater 19, the filter 29, the second valve 22, and the fourth valve 26.

As shown in Fig. 1, a motor 30 is provided inside the lid 13. For example, two cranks 32 are provided at the back surface 13b of the lid 13. Each of the cranks 32 is connected to a flat plate-shaped fixing member 34. The imagewise exposed flexographic printing plate precursor 36 is fixed to the fixing member 34 using a support plate 35. The support plate 35 is composed of, for example, an adhesive plate.

For example, an exposure device (not shown) imagewise exposes a front surface 36a of the flexographic printing plate precursor 36. The imagewise exposed front surface 36a of the flexographic printing plate precursor 36 is a development surface and becomes a printing surface.

In addition, one crank 32 of the two cranks 32 is connected to the motor 30. The two cranks 32 are connected to each other, and in a case where the one crank 32 rotates, the other crank 32 rotates in synchronization with the rotation. For this reason, in a case where the one crank 32 is rotated by the motor 30, the other crank 32 also rotates in synchronization with the rotation. Accordingly, the flexographic printing plate precursor 36 moves eccentrically. For example, a development unit 38 is composed of the motor 30, the cranks 32, the fixing member 34, and the brush 14.

In the washout processor 10, the brush 14 does not move, but the flexographic printing plate precursor 36 is moved in the washing solution Q such that an image forming surface of the flexographic printing plate precursor 36 moves eccentrically on the brush 14.

In addition, in the washout processor 10, although not shown, the lid 13 is opened, and the support plate 35 is fixed to the fixing member 34, for example, using a gluing agent. Accordingly, the flexographic printing plate precursor 36 can be fixed to the fixing member 34. In a case of removing the flexographic printing plate precursor 36, the lid 13 is opened, and the support plate 35 is removed from the fixing member 34. As shown in Fig. 3, in a case of moving and taking out the flexographic printing plate precursor 36 in the traveling direction D_{L}, solid contents are likely to be stuck to the front surface 36a of the flexographic printing plate precursor 36 on a liquid level Qs side due to the surface tension of the washing solution Q in a case where the solid contents float on the liquid level Qs of the washing solution Q. For this reason, as described above, in the second region D₂, as a flow of the washing solution Q in the direction F₁ from the liquid feeding port 28 toward the filter 29 is formed, the solid contents are prevented from being attached to the front surface 36a of the developed flexographic printing plate precursor 36 by the washing solution Q.

A liquid flow rate of the washing solution Q is preferably 50 cm/sec or more. In a case where the liquid flow rate of the washing solution Q is 50 cm/sec or more, attachment of solid contents or the like to the developed flexographic printing plate precursor 36 can be more reliably prevented, which is preferable. An upper limit of the liquid flow rate of the washing solution Q is not particularly limited, but is 200 cm/sec or less from pump performance or the like.

The liquid flow rate of the washing solution Q is a minimum speed of the washing solution Q and is, for example, a liquid flow rate at the side surface 12f of the developing tank 12.

The liquid flow rate of the washing solution Q can be measured using a thermal flow meter or the like, and specifically, for example, SI5007 manufactured by ifm efector Co., Ltd or the like is used.

### <Washing Method>

A washing method of the washout processor 10 will be described. The washing method means a developing method.

First, in the washing method, the imagewise exposed flexographic printing plate precursor 36 is attached to the support plate 35, and the support plate 35 is attached to the fixing member 34. The inside of the developing tank 12 is filled with the washing solution Q. Then, the lid 13 is closed. The flexographic printing plate precursor 36 is immersed in the washing solution Q. The image forming surface of the flexographic printing plate precursor 36, that is, the front surface 36a of the flexographic printing plate precursor 36 is brought into contact with the bristles 14b of the brush 14.

Next, the one crank 32 is rotated by the motor 30, the other crank 32 is also rotated in synchronization with the rotation, the flexographic printing plate precursor 36 is moved eccentrically, and the flexographic printing plate precursor 36 is developed in a state of being immersed in the washing solution Q.

In development, in order to promote development, for example, the temperature of the washing solution Q is adjusted at a constant temperature in a range of 40°C to 50°C by the heater 19, and the washing solution Q is kept in a state of being uniformly circulated in the developing tank 12.

In addition, the washing solution Q that has passed through the filter 18 is supplied from the supply port 15a into the developing tank 12 via the blowout port 15b, the washing solution Q in the developing tank 12 is taken in from the output port 16a via the suction port 16b by the circulation pump 17 and goes via the filter 18 and the heater 19, and the washing solution Q is supplied into the developing tank 12. The washing solution Q is circulated from the side surface 12c of the developing tank 12 toward the side surface 12d. Accordingly, a flow of the washing solution Q from the side surface 12c of the developing tank 12 toward the side surface 12d is formed. In addition, in this case, the washing solution Q is flowed parallel to the front surface of the flexographic printing plate precursor 36. In this case, in a state where the first valve 20 and the third valve 24 are open and a state where the second valve 22 and the fourth valve 26 are closed, a circulation path for the washing solution Q is configured.

As described above, as the washing solution Q flows from the blowout port 15b, the washing solution Q is taken in from the suction port 16b, and a flow of the washing solution from the side surface 12c toward the side surface 12d of the developing tank 12 is formed, the washing solution Q flowed in from the blowout port 15b simultaneously flows up and down with respect to the brush 14, and deposit of aggregated sediments on an edge part of the brush 14 and sedimentation of an unhardened portion on a bottom portion of the developing tank 12 can be suppressed.

After development, the lid 13 is opened, and the developed flexographic printing plate precursor 36 is taken out from the washing solution Q.

In development treatment, a solid content and a photosensitive resin aggregate of a non-exposed portion scraped off the flexographic printing plate precursor 36 sediment on the edge part of the brush 14 or the bottom portion of the developing tank 12. A resin component of the flexographic printing plate precursor 36, which is the non-exposed portion, has a low specific gravity and thereby aggregates or floats on the liquid level Qs while diffusing in the washing solution Q.

In a case of discharging the flexographic printing plate precursor 36, on which development treatment is performed, to the outside of the washing solution Q, in order to prevent solid contents dispersed or floating in the washing solution Q from being attached to the flexographic printing plate precursor 36, it is found that providing a flow of the washing solution Q in a direction intersecting the traveling direction in which the flexographic printing plate precursor 36 is discharged is effective in preventing attachment of the solid contents, instead of carrying the flexographic printing plate precursor 36 out of the washing solution Q from a state where the washing solution Q flows parallel to the front surface 36a of the flexographic printing plate precursor 36.

In addition, it is known that solid contents are likely to be attached to the front surface 36a of the developed flexographic printing plate precursor 36.

In a case of taking out the flexographic printing plate precursor 36 from the washing solution Q, in order to prevent solid contents floating in the washing solution Q from being attached to the flexographic printing plate precursor 36 even in a case where a washing solution circulation state where the solid contents are unlikely to be attached to the flexographic printing plate precursor 36 is kept in the washing solution Q, for example, as shown in Fig. 3, the flexographic printing plate precursor 36 is moved in the traveling direction D_{L} after development. In a case where the flexographic printing plate precursor 36 is raised from the washing solution Q, a flow of the washing solution Q is formed in a direction intersecting the traveling direction D_{L} of the flexographic printing plate precursor 36 at an interface between the flexographic printing plate precursor 36 and the washing solution Q. In this case, as the first valve 20 and the third valve 24 are closed, the second valve 22 and the fourth valve 26 are opened, and a flow of the washing solution Q in the direction F₁ from the liquid feeding port 28 toward the filter 29 is formed in the second region D₂, the floating solid contents flow while riding a liquid flow, so that the solid contents are prevented from being attached to the flexographic printing plate precursor 36. In addition, the solid contents are captured by the filter 29.

In a case of forming the flow of the washing solution Q in the direction F₁ described above, the second valve 22 and the fourth valve 26 are opened, and the first valve 20 and the third valve 24 are closed, but the configuration is not limited thereto. In this case, a flow of the washing solution Q from the side surface 12c toward the side surface 12d decreases simply by narrowing the first valve 20 and the third valve 24.

The configuration of the washout processor 10 is not limited to the configuration shown in Fig. 1 and may be other configurations.

### (Second Example of Washout Processor)

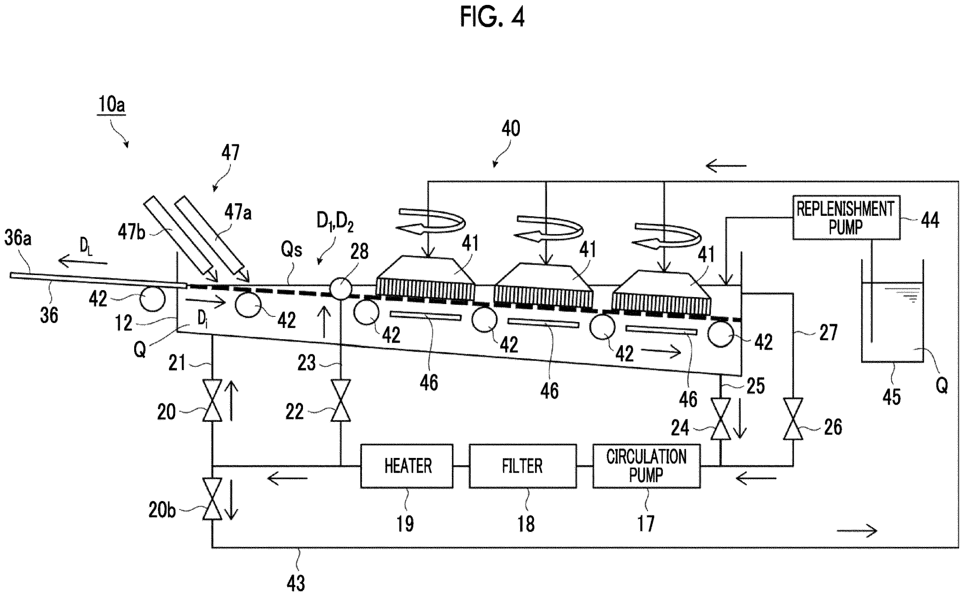

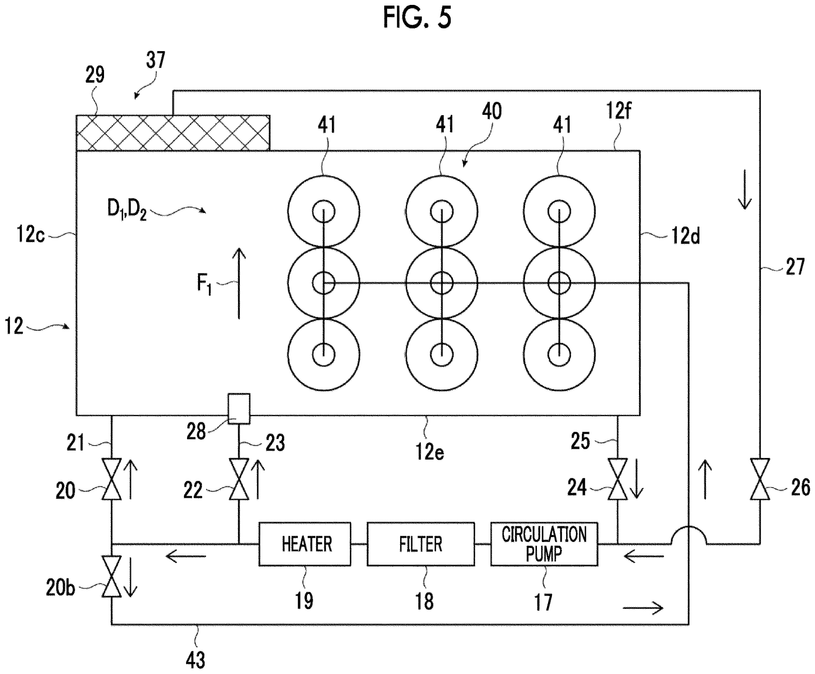

Fig. 4 is a schematic side view showing a second example of the washout processor according to the embodiment of the present invention. Fig. 5 is a schematic plan view showing the second example of the washout processor according to the embodiment of the present invention.

In Figs. 4 and 5, the same components as those of the washout processor 10 shown in Figs. 1 and 2 will be assigned with the same reference numerals, and detailed description thereof will be omitted. In addition, a control unit is not shown in Figs. 4 and 5, but each unit of a washout processor 10a is controlled by the control unit.

The washout processor 10a shown in Fig. 4 has a development unit 40 that removes and develops a non-exposed portion of an imagewise exposed flexographic printing plate precursor using the washing solution Q.

As shown in Fig. 5, the first valve 20 is connected to the side surface 12e of the developing tank 12 via the pipe 21. The second valve 22 is connected to the side surface 12e of the developing tank 12 via the pipe 23. The third valve 24 is connected to the side surface 12e of the developing tank 12 via the pipe 25.

As shown in Fig. 4, the development unit 40 is disposed at the developing tank 12 and has a plurality of brushes 41.

A plurality of transport rollers 42 are provided in the developing tank 12. A support body 46 that supports the flexographic printing plate precursor 36 is provided between the transport rollers 42. Each brush 41 is disposed on each support body 46. For example, as shown in Fig. 5, although the brushes 41 are disposed in three lines with three brushes as a line, the number of brushes 41 and the number of lines are not particularly limited. In addition, a brush shape may be a polygon in addition to a circle, is not particularly limited, and is determined by the configuration of the washout processor 10a as appropriate. The support body 46 shown in Fig. 4 may not be included.

The brush 41 is connected to the connecting pipe 43. The connecting pipe 43 is connected to the circulation pump 17, the filter 18, and the heater 19, and a fifth valve 20b is provided at the connecting pipe 43. The washing solution Q or a regenerated washing solution is supplied to the brushes 41 through the connecting pipe 43. By opening and closing the fifth valve 20b, the supply of the washing solution Q or the regenerated washing solution to the brushes 41 is controlled.

In addition, a base (not shown) on which the flexographic printing plate precursor 36 is placed may be provided adjacent to the developing tank 12. The flexographic printing plate precursor 36 is sent out from the base to the transport rollers 42, and the flexographic printing plate precursor 36 is transported in a carry-in direction Di by the transport rollers 42. In addition, the flexographic printing plate precursor 36 is transported also in an opposite direction to the carry-in direction Di by the transport rollers 42.

A method of carrying in the flexographic printing plate precursor 36 in a state of being fixed to the support plate 35 (see Fig. 1) may be adopted, like the washout processor 10 shown in Fig. 1. In a case of using the support plate 35 (see Fig. 1), the flexographic printing plate precursor 36 is fixed to the support plate 35 such that an imagewise exposure surface becomes a brush side.

In the washout processor 10a, the flexographic printing plate precursor 36 is transported to the developing tank 12 along one determined transport path and is carried out from the developing tank 12. The flexographic printing plate precursor 36 carried into the washing solution Q and the flexographic printing plate precursor 36 carried out from the washing solution Q pass through the same region. For this reason, in the washout processor 10a, a first region Di where the flexographic printing plate precursor 36 is carried into the washing solution Q of the developing tank 12 and the second region D₂ where the flexographic printing plate precursor 36 is carried out from the washing solution Q of the developing tank 12 are the same region. Although the same region means that carrying-in and carrying-out of the flexographic printing plate precursor 36 with respect to the washing solution Q are performed at the same region, regions for carrying-in and carrying-out of the flexographic printing plate precursor 36 may include a transport error and are not limited to a complete match.

Although the first region Di and the second region D₂ are the same region, the washout processor 10a is not limited thereto, and the first region Di and the second region D₂ may be regions different from each other. In this case, for example, by changing a transport path through which the flexographic printing plate precursor 36 is carried into the developing tank 12 and a transport path through which the flexographic printing plate precursor is carried out from the developing tank 12, the first region Di and the second region D₂ can be made regions different from each other. A transport path difference between carrying-in and carrying-out of the flexographic printing plate precursor 36 is a difference exceeding a transport error of carrying-in and carrying-out of the flexographic printing plate precursor 36 described above.

The plurality of brushes 41 are rotated about a rotation axis (not shown) by a driving unit (not shown). In addition, during development, the washing solution Q or a regenerated washing solution is supplied to the brushes 41 via the rotation axis. The washing solution Q or the regenerated washing solution is supplied from the brushes 41 to the front surface 36a of the flexographic printing plate precursor 36.

The front surface 36a of the flexographic printing plate precursor 36 is rubbed by the plurality of brushes 41, and development is performed by removing a non-exposed portion (not shown) of the flexographic printing plate precursor 36.

For example, brushes obtained by bundling bristles perpendicular to a substrate are used as the brushes 41. In the configuration, the bristles of the brushes 41 are substantially perpendicular to the front surface 36a of the flexographic printing plate precursor 36. The bristles of the brushes 41 are not particularly limited. The bristles are made of the same material as the brush 14 (see Fig. 1) described above.

The brushes 41 may be stationary, that is, fixed to the front surface 36a of the flexographic printing plate precursor 36, or may be configured to move with respect to the front surface 36a of the flexographic printing plate precursor 36. In this case, the movement of the brushes 41 is not particularly limited and may be any one of rotation, reciprocation, a combination of rotation and reciprocation, or eccentric movement.

In a case where the brushes 41 move, the brushes 41 may move at all times during development or may move only when the flexographic printing plate precursor 36 is transported to the developing tank 12. In this case, for example, a sensor (not shown) that detects the flexographic printing plate precursor 36 is provided at the transport roller 42 through which the flexographic printing plate precursor 36 first passes, a time when the brushes 41 are reached is identified using a transport timing and the transportation speed of the flexographic printing plate precursor 36, and development can be performed by moving the brushes 41.

A replenishment pump 44 and a replenishment tank 45 are provided. The replenishment tank 45 stores the washing solution Q. The washing solution Q stored in the replenishment tank 45 is supplied into the developing tank 12 by the replenishment pump 44.

In addition, a rinsing unit 47 is provided. The rinsing unit 47 supplies a rinsing liquid to the front surface 36a of the flexographic printing plate precursor 36 and removes residues remaining on the front surface 36a of the developed flexographic printing plate precursor 36 such as latex components and rubber components using the rinsing liquid.

The rinsing liquid is a liquid of which substantially only component is water, and for example, fresh water, tap water, industrial water, ground water, and the like can be used. The substantially only water means that water is 99.50% by mass or more as a component of the rinsing liquid, and water preferably exceeds 99.99% by mass and is most preferably only water.

The rinsing unit 47 has a rinsing liquid supply unit 47a and a liquid drain nozzle 47b.

The liquid drain nozzle 47b is provided on a downstream side of the rinsing liquid supply unit 47a in the traveling direction D_{L} of the flexographic printing plate precursor 36, that is, a downstream side in the carry-in direction Di.

The rinsing liquid supply unit 47a supplies, for example, a rinsing liquid from the nozzle to the front surface 36a of the flexographic printing plate precursor 36.

For example, the sensor (not shown) that detects the flexographic printing plate precursor 36 is provided, a timing when the flexographic printing plate precursor 36 passes through the brushes 41 on a base side is detected, and the rinsing liquid is supplied from the rinsing liquid supply unit 47a of the rinsing unit 47 to at least the front surface 36a of the developed flexographic printing plate precursor 36 from which a non-exposed portion is removed via the nozzle.

The liquid drain nozzle 47b removes the rinsing liquid supplied to the flexographic printing plate precursor 36 by the rinsing liquid supply unit 47a by jetting a gas or removes the rinsing liquid by sucking a gas. Insofar as the jetting of the gas or the sucking of the gas can be performed, the configuration of the liquid drain nozzle 47b is not particularly limited, and various types of pumps can be used.

As the rinsing unit 47 is provided with the rinsing liquid supply unit 47a and the liquid drain nozzle 47b, the liquid drain nozzle 47b entrains a rinsing liquid from the rinsing liquid supply unit 47a, the rinsing liquid spreads on the front surface 36a of the flexographic printing plate precursor 36 even in a case where a supply amount of the rinsing liquid from the rinsing liquid supply unit 47a is small, and thereby the non-exposed portion described above can be removed. Accordingly, the amount of the rinsing liquid necessary for removing residues such as latex components and rubber components remaining on the front surface 36a of the developed flexographic printing plate precursor 36 can be decreased.

It is preferable to drive the rinsing liquid supply unit 47a and the liquid drain nozzle 47b simultaneously. By driving the rinsing liquid supply unit 47a and the liquid drain nozzle 47b simultaneously, the effect of entrainment of the rinsing liquid described above is further obtained.

### <Washing Method>

A washing method of the washout processor 10a will be described. In the washout processor 10a, development is performed in a state where the brushes 41 are in the washing solution Q. Accordingly, an aggregate is prevented from being deposited on the brushes 41, and solid contents accumulated in the brushes 41 are prevented from being peeled off and attached to the flexographic printing plate precursor 36.

The washing solution Q of the developing tank 12 is circulated via the filter 18 and the heater 19 by the circulation pump 17 with the first valve 20 and the third valve 24 opened and is heated to a set temperature. In a case where the set temperature is, for example, a temperature of 50°C and the temperature is in a constant state of 50°C, the first valve 20 is closed, the fifth valve 20b is opened, and the washing solution Q is supplied to a brush 41 side, circulating the washing solution Q.

For example, in a case where the brushes 41 have a plurality of bristles implanted in a substrate, the washing solution Q supplied to each brush 41 is jetted from between the implanted bristles through holes in the substrate. In this state, the flexographic printing plate precursor 36 is slid on the transport rollers 42 and is moved in the carry-in direction Di. Then, for example, the brushes 41 are moved eccentrically, performing development.

After the development, the flexographic printing plate precursor 36 is moved in the traveling direction D_{L}. In this case, the flexographic printing plate precursor 36 is carried out from the washing solution Q.

After development, the rinsing unit 47 raises the flexographic printing plate precursor 36 from the washing solution Q while jetting a rinsing liquid to the front surface 36a of the flexographic printing plate precursor 36. In this case, in a state where the first valve 20, the fifth valve 20b, and the third valve 24 are closed and the second valve 22 and the fourth valve 26 are opened, the washing solution Q is flowed by the circulation pump 17. In this case, in the second region D₂ (see Fig. 5) including the interface between the flexographic printing plate precursor 36 and the washing solution Q described above, a flow of the washing solution Q is formed in the direction F₁ (see Fig. 5) as described above. Accordingly, solid contents are prevented from being attached to the flexographic printing plate precursor 36 as the solid contents floating in the second region D₂ are swept away by the flow of the washing solution Q, thereby obtaining a good development finish.

In a case where the flexographic printing plate precursor 36 is moved in a transport direction and is raised from the washing solution Q of the developing tank 12 in a state where the second valve 22 is closed and a state where the first valve 20 and the fifth valve 20b are opened, a flow of the washing solution Q is not formed in the direction F₁, and solid contents cannot be prevented from being attached to the flexographic printing plate precursor 36 in the second region D₂ described above.

As shown in Fig. 4, the second region D₂ is also the first region Di where the flexographic printing plate precursor 36 is carried in. That is, as described above, the first region Di and the second region D₂ are the same region.

### (Third Example of Washout Processor)

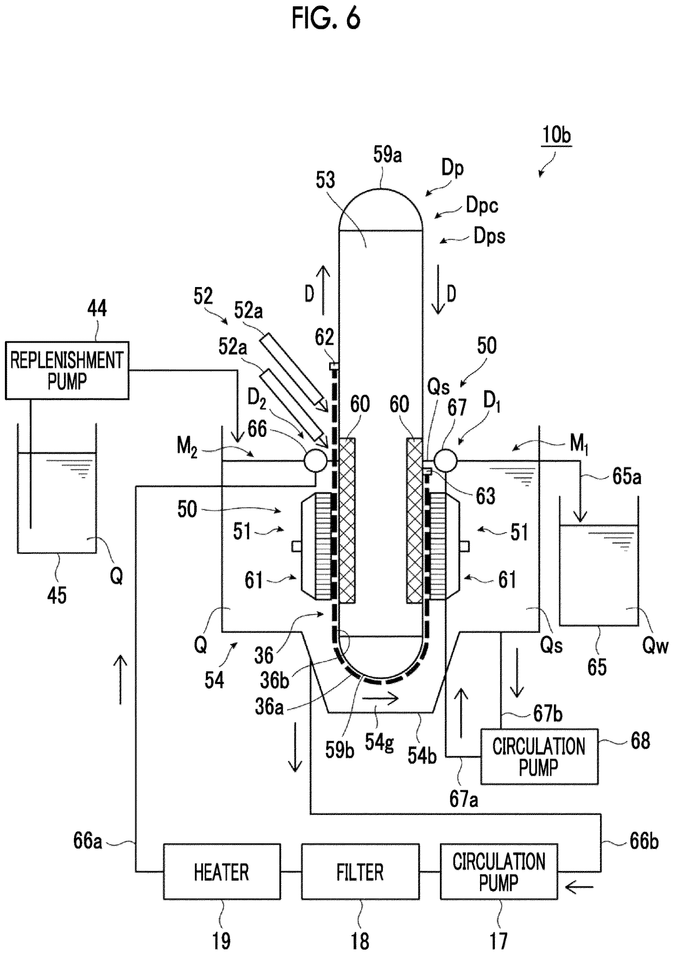

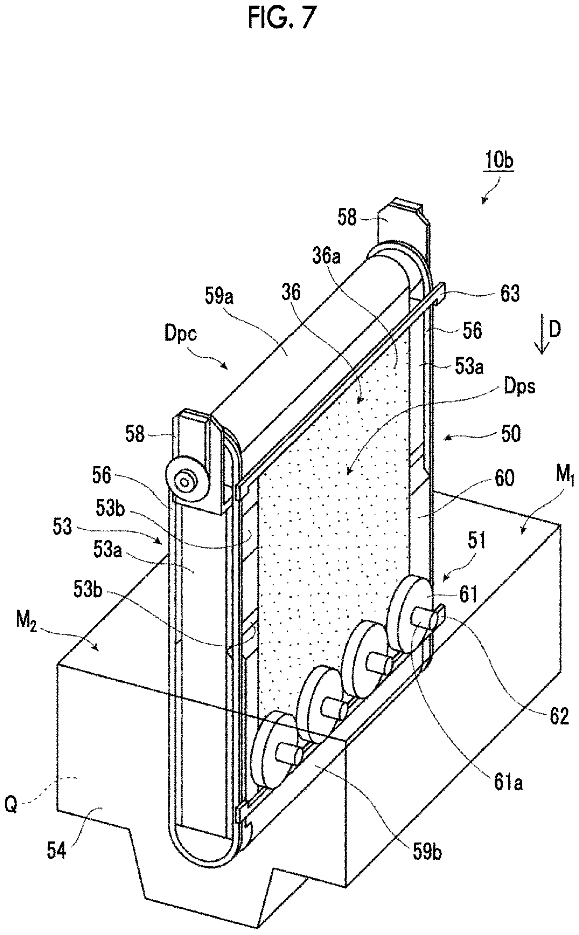

Fig. 6 is a schematic side view showing a third example of the washout processor according to the embodiment of the present invention, Fig. 7 is a schematic plan view showing the third example of the washout processor according to the embodiment of the present invention, and Fig. 3 is a schematic plan view showing main portions of the example of the washout processor according to the embodiment of the present invention.

In Figs. 6 to 8, the same components as those of the washout processor 10 shown in Figs. 1 and 2 will be assigned with the same reference numerals, and detailed description thereof will be omitted.

A washout processor 10b shown in Fig. 6 is a vertical transport type washout processor. The washout processor 10b is a device that develops the imagewise exposed flexographic printing plate precursor 36, of which the front surface 36a is imagewise exposed, using the washing solution Q, while transporting the flexographic printing plate precursor and is a washout processor that develops the flexographic printing plate precursor 36 in a state of being transported along a determined transport path Dp. Performing development using the washing solution Q described above is referred to as a developing step. As shown in Fig. 6, the transport path Dp for the flexographic printing plate precursor 36 has a curved transport passage Dpc and a linear transport passage Dps. The transport path Dp shown in Fig. 6 is a go-around transport path having the curved transport passage Dpc, the linear transport passage Dps, and the curved transport passage Dpc. For this reason, as will be described later, the flexographic printing plate precursor 36 can be developed by making the flexographic printing plate precursor go around a plurality of times.

As will be described later, the flexographic printing plate precursor 36 has a small thickness of approximately several millimeters and is flexible enough to be curved and transported in a developing tank 54.

In the washout processor 10b, the imagewise exposed flexographic printing plate precursor 36, which is in a state of being immersed in the washing solution Q and being transported, is developed with a non-exposed portion (not shown) of the flexographic printing plate precursor 36 removed. The washout processor 10b is a device that performs development while transporting the flexographic printing plate precursor 36 along a determined transport path. In a washing method using the washout processor 10b, the flexographic printing plate precursor 36 is developed while being transported along the determined transport path Dp.

The expressions that while transporting the flexographic printing plate precursor 36 described above and a state where the flexographic printing plate precursor 36 is transported mean moving the flexographic printing plate precursor 36 along the transport path Dp.

The washout processor 10b has a transporting unit 50, a development unit 51, and a rinsing unit 52.

Although the transporting unit 50 and the development unit 51 are provided at a frame 53 in the washout processor 10b, the invention is not limited to the configuration.

In the washout processor 10b, for example, the flexographic printing plate precursor 36 that has gone via the rinsing unit 52 is taken out. A position where the flexographic printing plate precursor 36 in the washout processor 10b is taken out is not particularly limited.

The outer shape of the frame 53 is, for example, a rectangular shape. Two members 53a of the frame 53 extending in one direction as shown in Fig. 7 are disposed in parallel. In a direction orthogonal to a longitudinal direction of the members 53a, beam members 53b are disposed at both ends and the center of the members 53a in the longitudinal direction. Between the beam members 53b provided at both ends of the member 53a of the frame 53 in the longitudinal direction is the linear transport passage Dps. For example, up to the center of the members 53a of the frame 53, that is, up to the beam member 53b at the center, the linear transport passage is disposed in the developing tank 54. The developing tank 54 is a container in which the washing solution Q is stored. The development unit 51 is disposed in the linear transport passage Dps in the developing tank 54.

The developing tank 54 has a first tank portion M₁ and a second tank portion M₂ with which the washing solution Q communicates. The flexographic printing plate precursor 36 is carried into the first tank portion M₁, and the developed flexographic printing plate precursor 36 is carried out from the second tank portion M₂. The first region Di is in the first tank portion M₁, and the second region D₂ is in the second tank portion M₂. The first region Di includes the interface between the flexographic printing plate precursor 36 and the washing solution Q.

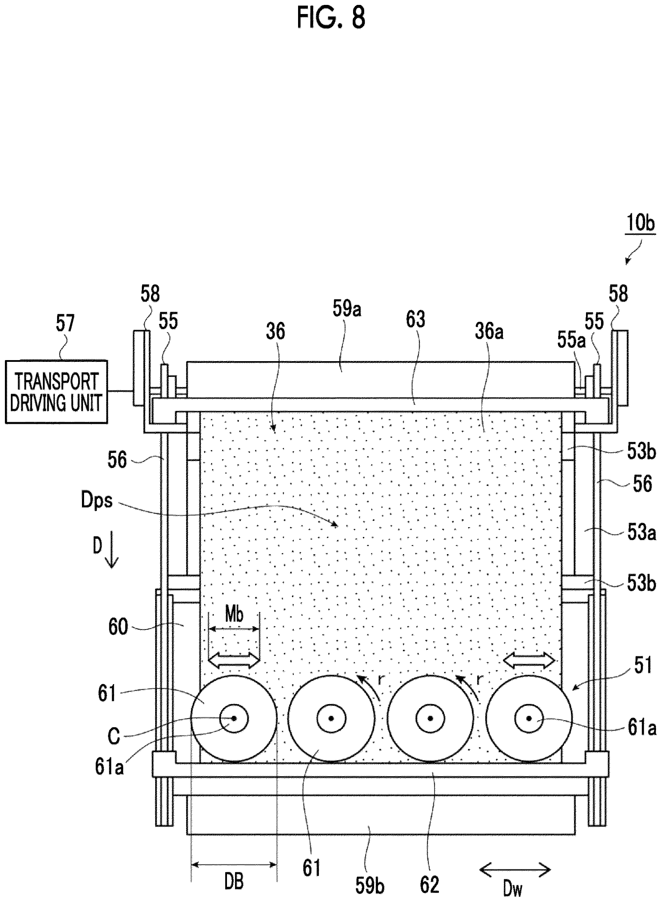

As shown in Fig. 8, for example, gears 55 are rotatably provided at both ends of each member 53a in the longitudinal direction. The gears 55 facing each other in the longitudinal direction of the beam members 53b are connected by a shaft 55a. In each member 53a, a transport chain 56 is hung on a pair of gears 55 facing each other in the longitudinal direction. The pair of transport chains 56 are disposed to face each other in the longitudinal direction of the beam members 53b of the frame 53.

For example, a transport driving unit 57 is connected to one of the plurality of gears 55. The gears 55 are rotated by the transport driving unit 57, and the transport chains 56 move in a specific direction. A method of connecting between the gears 55 and the transport driving unit 57 is not particularly limited. The gears and the transport driving unit may be connected to each other by a shaft or the like or may be connected to each other using a chain or a belt.

The transporting unit 50 is composed of the gears 55, the transport chains 56, and the transport driving unit 57. The flexographic printing plate precursor 36 is transported by the transporting unit 50 in a state of being immersed in the washing solution Q in the developing tank 54.

The transporting unit 50 preferably has a tension adjusting unit 58 (see Fig. 7) that adjusts the tension of the flexographic printing plate precursor 36 during transporting. In a case where the tension of the transport chain 56 is low, the tension of the flexographic printing plate precursor 36 during transporting is low, the flexographic printing plate precursor 36 is loosened during transporting, and the flexographic printing plate precursor 36 is not stably transported. In addition, in a case where the tension of the transport chain 56 is low, the transport chain 56 is disengaged from the gear 55 in some cases. For this reason, the tension adjusting unit 58 that adjusts the tension of the transport chain 56 is provided at an end part of the member 53a in order to adjust the tension of the flexographic printing plate precursor 36 during transporting. The tension of the flexographic printing plate precursor 36 during transporting can be adjusted by the tension adjusting unit 58, and the flexographic printing plate precursor 36 is prevented from being loosened during transporting.

Insofar as the tension of the flexographic printing plate precursor 36 during transporting can be adjusted, a position where the tension adjusting unit 58 is disposed and a configuration thereof are not particularly limited, and a known unit can be used as appropriate. For example, it is possible to use a unit that changes a distance between the gears 55 on which the transport chains 56 are hung, a unit that applies tension by pressing the gears against the transport chain 56, or the like as appropriate.

The transporting unit 50 may have a guide mechanism that guides the transport chain 56. The guide mechanism can suppress meandering of the transport chain 56 or the like. The guide mechanism is composed of, for example, a member that is provided on an opposite side of the transport chain 56 where the flexographic printing plate precursor 36 is disposed and is inserted between rollers (not shown) of the transport chains 56. This member is formed of, for example, high molecular weight polyethylene or a fluororesin such as polytetrafluoroethylene (PTFE).

A turn bar 59a and a turn bar 59b (see Fig. 7) are provided at the beam members 53b at ends of the members 53a respectively in the longitudinal direction. The turn bars 59a and 59b are composed of a semi-cylindrical member, and the semi-cylindrical member is provided with a plane portion facing a beam member 53b side.

The semi-cylindrical turn bars 59a and 59b are provided at bending parts composed of the curved transport passages. That is, the curved transport passages Dpc are composed of the semi-cylindrical turn bars 59a and 59b, and the flexographic printing plate precursor 36 is transported along surfaces of the turn bars 59a and 59b. In this case, a back surface 36b of the flexographic printing plate precursor 36 comes into contact with the turn bars 59a and 59b. The turn bars 59a and 59b each are composed of a semi-cylindrical member having a size corresponding to the curvature of the curved transport passage Dpc or the like.

Since the turn bars 59a and 59b are brought into contact with the flexographic printing plate precursor 36, at least, surfaces brought into contact with the flexographic printing plate precursor 36 preferably have a low frictional resistance. As the frictional resistance is low, the flexographic printing plate precursor 36 can be smoothly transported without damaging the back surface 36b or the like. The turn bars 59a and 59b suppress tension fluctuations in the curved transport passages Dpc during transporting of the flexographic printing plate precursor 36.

The turn bar 59a and the turn bar 59b are provided at the ends of the members 53a in the longitudinal direction, and the turn bar 59b is immersed in the developing tank 54 storing the washing solution Q.

In addition, the flexographic printing plate precursor 36 is attached to a trailing end leader 63 in a state where the flexographic printing plate precursor 36 is hung on the turn bar 59a among the turn bar 59a and the turn bar 59b. The turn bar 59a moves forward and backward with respect to the curved transport passage Dpc. In a case where the turn bar 59a has entered the curved transport passage Dpc, the turn bar is brought into contact with the flexographic printing plate precursor 36. On the other hand, in a case where the turn bar 59a has moved backward with respect to the curved transport passage Dpc, a transport length of the flexographic printing plate precursor 36 is shortened, and a short pass state to be described later is caused. Specifically, as the turn bar 59a moves up and down with respect to the beam members 53b, the turn bar moves forward and backward with respect to the curved transport passage Dpc. For example, a linear motion mechanism using a solenoid is provided, for example, between the turn bar 59a and the beam member 53b. For example, a configuration where the turn bar 59a is lowered in a state where the solenoid is turned off and the turn bar 59a is raised in a state where the solenoid is turned on is adopted. Accordingly, in a case of fixing the flexographic printing plate precursor 36, the turn bar 59a can be lowered.

By raising and lowering the turn bar 59a, tension applied to the flexographic printing plate precursor 36 can be changed. The turn bar 59a functions as a tension applying unit. With the tension applying unit, by raising the turn bar 59a after fixing the flexographic printing plate precursor 36 to the leader, a force is applied in a direction in which the length of the flexographic printing plate precursor 36 extends in a state where the flexographic printing plate precursor 36 is fixed to the leader, and the tension of the flexographic printing plate precursor 36, that is, tension after fixing the flexographic printing plate precursor 36 to the leader can be made higher than tension in a case of fixing the flexographic printing plate precursor 36.

The tension in a case of fixing the flexographic printing plate precursor 36 is the tension of the flexographic printing plate precursor 36 in a state where the turn bar 59a is lowered. The tension after fixing the flexographic printing plate precursor is the tension of the flexographic printing plate precursor 36 in a state where the turn bar 59a is raised.

The magnitude of the tension of the flexographic printing plate precursor 36 can be identified by the tension of the flexographic printing plate precursor 36.

In a case where the tension of the flexographic printing plate precursor 36 is high, that is, the flexographic printing plate precursor 36 extends, vertical creases are generated in the flexographic printing plate precursor 36. On the other hand, in a case where the tension of the flexographic printing plate precursor 36 is low, that is, the flexographic printing plate precursor 36 loosens, horizontal creases are generated. Both the vertical creases and the horizontal creases cause development defects. An operator visually checks the vertical creases and the horizontal creases and can start transporting with a state where none of the creases are generated as appropriate tension. It is preferable to provide a device that measures the tension of the flexographic printing plate precursor 36 in the tension applying unit or the transport path and to adjust the tension of the flexographic printing plate precursor 36 such that the tension is within a certain range.

Next, the device that measures the tension of the flexographic printing plate precursor 36 or the like will be described.

In a state where the flexographic printing plate precursor 36 is fixed to the leader, a state where the turn bar 59a is raised is visually checked with the solenoid turned on, and a position where the solenoid is attached or a stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where a drive unit or an electric actuator composed of a ball screw, a linear guide, a servo motor, or the like is used, linear motion can be randomly made not only in an on state and an off state but also in a certain range, and the tension can be finely adjusted. In a case where the linear motion mechanism is configured to operate the tension applying unit via a load cell or a strain gauge, tension applied to the flexographic printing plate precursor 36 can be measured. By quantifying a tension range in a state where vertical creases and horizontal creases are not visually generated in the flexographic printing plate precursor 36, in a state where the flexographic printing plate precursor 36 is fixed to the leader according to various types such as a width, a length, and a thickness of the flexographic printing plate precursor 36, a state where the turn bar 59a is raised with the solenoid turned on is visually checked, and a position where the solenoid is attached or the stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where the drive unit or the electric actuator composed of the ball screw, the linear guide, the servo motor, or the like is used, linear motion can be randomly made not only in the on state and the off state but also in a certain range, and tension applied to the flexographic printing plate precursor 36 can be finely adjusted. In a case where the linear motion mechanism is configured to operate the tension applying unit via a load cell or a strain gauge, tension applied to the flexographic printing plate precursor 36 can be measured. By quantifying a tension range in a state where vertical creases and horizontal creases are not visually generated in the flexographic printing plate precursor 36, an appropriate tension state according to various types such as the width, the length, and the thickness of the flexographic printing plate precursor 36 is easily set.

As a tension measurer, a tension controller is preferable.

The tension applying unit is not limited to the turn bar 59a described above, and a roller (not shown) can also be used instead of the turn bar 59a. In a case where the roller is provided, as in the turn bar 59a described above, the roller is configured to move forward and backward with respect to the curved transport passage Dpc, and tension can be applied to the flexographic printing plate precursor 36 in a case where the roller has entered the curved transport passage Dpc.

The surfaces of the turn bars 59a and 59b, which are brought into contact with the flexographic printing plate precursor 36, are composed of, for example, resin layers, plating layers, or diamond-like carbon layers (DLC layers). The resin layer can be formed of a fluororesin, such as polytetrafluoroethylene (PTFE) and high-density polyethylene. The plating layer is, for example, hard chrome plating. In addition thereto, a titanium nitride (TiN) layer or the like can be used. Further, a nonwoven fabric can also be used as the turn bars 59a and 59b. In a case of using the nonwoven fabric, an attachment on the back surface 36b of the flexographic printing plate precursor 36 can be removed.

In addition, a plurality of uneven portions may be formed in the surfaces of the turn bars 59a and 59b, which are brought into contact with the flexographic printing plate precursor 36. As the plurality of uneven portions are formed, a contact area reduces, and a frictional resistance decreases. An example in which the plurality of uneven portions are formed includes a metal plate such as an embossed stainless steel plate.

The turn bars 59a and 59b may be entirely formed of a material forming the surfaces brought into contact with the flexographic printing plate precursor 36.

Since the turn bar 59b is used in a state of being immersed in the washing solution Q in some cases, it is preferable that the turn bar 59b does not dissolve in the washing solution Q, does not deteriorate due to the washing solution Q, or does not deform, such as swelling, due to the washing solution Q.

In addition, a back plate portion 60 with which the flexographic printing plate precursor 36 is brought into contact is provided between the beam member 53b at the center of the member 53a of the frame 53 and the beam member 53b at the end. For example, the back plate portion 60 is provided on a back surface 36b side of the flexographic printing plate precursor 36.

Since the back plate portion 60 is brought into contact with the flexographic printing plate precursor 36, a surface brought into contact with the flexographic printing plate precursor 36 is preferably a plane. As the surface brought into contact with the flexographic printing plate precursor 36 is a plane, the flexographic printing plate precursor 36 can be efficiently washed.

The back plate portion 60 is formed of, for example, a metal. The metal is preferably stainless steel, titanium, or the like, the surface of the back plate portion 60 brought into contact with the flexographic printing plate precursor 36 may be plated, and the plating is preferably hard chrome plating and is more preferably diamond-like carbon (DLC) processing. In addition thereto, surface treatment with titanium nitride (TiN) or the like may be performed on the surface brought into contact with the flexographic printing plate precursor 36.

In addition, for example, nip rolls (not shown) may be provided to face the back plate portion 60 at intervals in the longitudinal direction of the members 53a. Although the flexographic printing plate precursor 36 has flexibility, the nip rolls suppress deflection or the like during transporting so that the flexographic printing plate precursor 36 can be stably transported, and even in a case where a brush 61 rotates or moves particularly during development, the flexographic printing plate precursor 36 can be stably transported. The nip rolls are not limited to three.

In order not to damage the printing surface, that is, the front surface 36a of the flexographic printing plate precursor 36, for example, rubber rollers, sponge rollers, rotary brushes, or the like are preferably used as the nip rolls.

Since the flexographic printing plate precursor 36 has flexibility as described above, there is a possibility that a non-exposed portion cannot be efficiently removed by the brush 61 due to deflection or the like in a case of being rubbed against the brush 61. As the back plate portion 60 described above is provided, the back surface 36b of the flexographic printing plate precursor 36 is supported by the back plate portion 60 in a case of removing the non-exposed portion by the brush 61, so that the non-exposed portion can be efficiently removed. In addition, the back plate portion 60 functions as a transport guide, and thus the flexographic printing plate precursor 36 can be more stably transported by the back plate portion 60.

The development unit 51 (see Fig. 8) may be configured such that a plurality of brushes 61, for example, four brushes 61 are arranged in a line in a direction Dw. The brush 61 is disposed such that a rotation axis C is in a direction perpendicular to the front surface 36a of the flexographic printing plate precursor 36.

The four brushes 61 are connected to the driving unit (not shown), and the driving unit controls the rotation of the brushes 61 about the rotation axes C and the movement of the brushes 61.

Development can be simultaneously performed by the four brushes 61. Accordingly, an area rubbed by the brushes 61 can be increased, and a development speed can be increased in a state where the attachment of development residues is suppressed and development uniformity is maintained. In this case, the rotation speeds of the plurality of brushes 61 may be the same, or the rotation speed may be changed for each of the plurality of brushes 61. In addition, the sizes of the four brushes 61 may be the same or may be different from each other. However, it is preferable for the four brushes 61 to have the same size and rotation speed from a perspective of development uniformity for suppressing the occurrence of development unevenness.

The rotation about the rotation axis C of the brush 61 described above is rotation of the brush 61 with the rotation axis C as a rotation center, and the brush 61 spins. The rotation axis C is a fixed axis passing through one point in the brush 61. A rotation shaft portion 61a is provided at the brush 61, and a central axis of the rotation shaft portion 61a is the rotation axis C. The rotation shaft portion 61a functions as a rotation drive shaft that is rotated as power is transmitted from the driving unit, and the brush 61 spins, for example, in a rotation direction r as the rotation shaft portion 61a is rotated.

In addition, it is preferable to move the four brushes 61 in a width direction of the flexographic printing plate precursor 36, that is, the direction Dw orthogonal to a transport direction D. That is, it is preferable to swing the plurality of brushes 61 in the direction Dw. In this case, it is preferable to move by a distance of one third or more of a diameter DB (see Fig. 8) of the brush 61. The distance by which the brush 61 is moved in the direction Dw is referred to as a swing width Mb.

As described above, by swinging the brush 61 in the direction Dw, the occurrence of development unevenness can be suppressed. Setting the swing width Mb to the distance of one third or more of the diameter DB (see Fig. 8) of the brush 61 is preferable since the occurrence of development unevenness can be suppressed even better.

In a case where a plurality of brushes are provided, for example, at least two brushes may be simultaneously driven by one motor instead of rotating each brush. In a case of the four brushes 61, the four brushes 61 may be simultaneously driven by one motor instead of rotating each brush 61. Accordingly, the number of motors can be reduced, and thus the device can be decreased in size. In addition, in a case where the plurality of brushes are rotated by one motor, the number of rotations can be changed for each brush 61 by providing a transmission. Accordingly, the number of motors can be reduced, and thus the device can be decreased in size. In addition, in a case where the plurality of brushes are rotated by one motor, the number of rotations can be changed for each brush 61 by providing a transmission.

For the brushes 61, a configuration where two brushes 61 are disposed in the transport direction D of the transport path Dp may be adopted.

In addition, it is preferable that the washout processor 10b has at least two types of brushes used in development, and one type of at least two types of brushes is a brush of which the rotation axis C is disposed in a direction perpendicular to the flexographic printing plate precursor 36. By disposing the rotation axis C parallel to the front surface 36a of the flexographic printing plate precursor 36, development can be efficiently performed.

For example, in the development unit 51, a roller brush that is used in finishing of development may be disposed on an upstream side (first region Di) of the transport path Dp for the flexographic printing plate precursor 36 in the transport direction D. The roller brush is disposed in a state of being immersed in the liquid level Qs of the washing solution Q. Having the roller brush that is used in finishing of development is preferable since on-plate residues or the like are removed, but it is not always necessary to provide the roller brush.

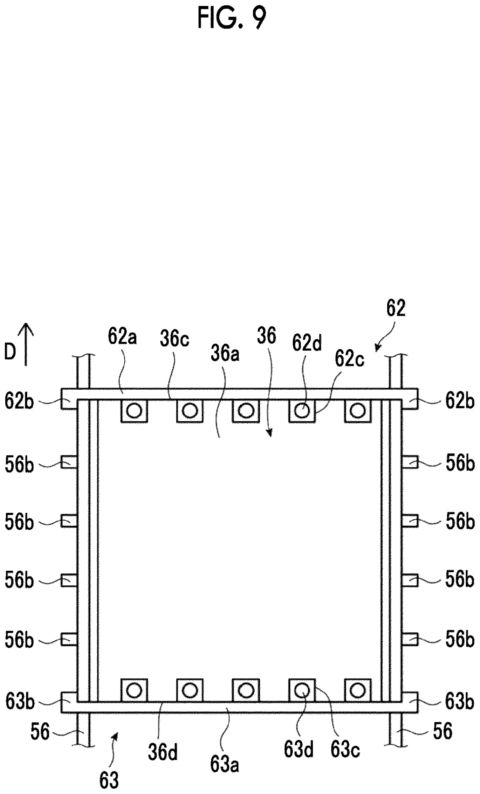

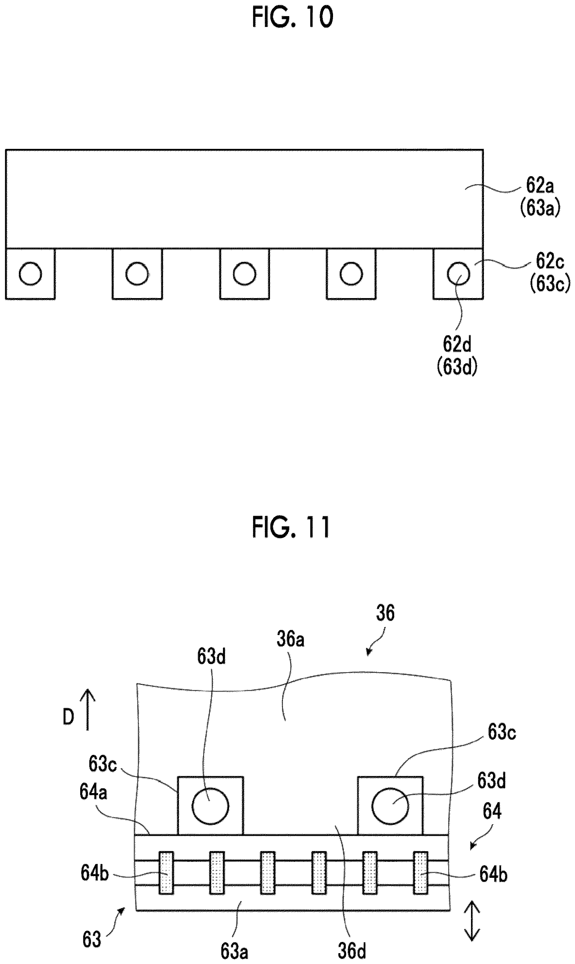

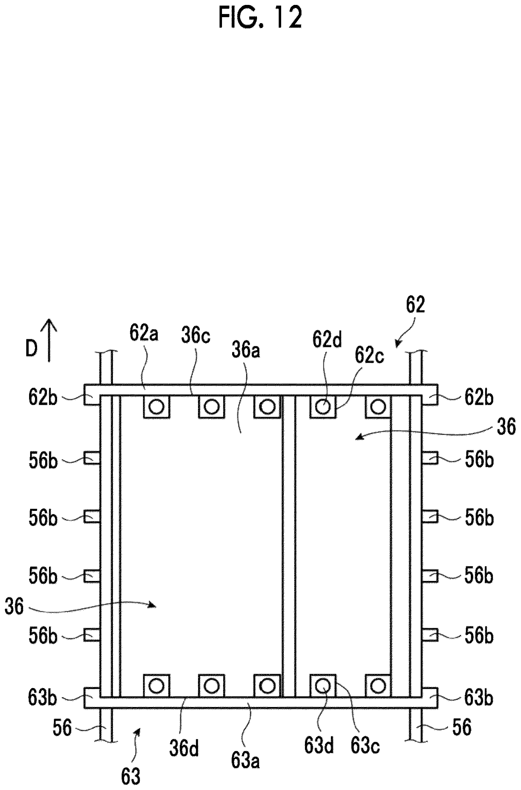

Herein, Fig. 9 is a schematic plan view showing a transporting form of the flexographic printing plate precursor according to the embodiment of the present invention, and Fig. 10 is a schematic view showing an example of a leading end leader used in transporting the flexographic printing plate precursor according to the embodiment of the present invention. Fig. 11 is a schematic view showing a leader mechanism portion used in transporting the flexographic printing plate precursor according to the embodiment of the present invention. In addition, Fig. 12 is a schematic plan view showing another example of the transporting form of the flexographic printing plate precursor according to the embodiment of the present invention.

The transporting unit 50 (see Fig. 6) fixes the leader to the pair of transport chains 56 (see Fig. 9) and transports the flexographic printing plate precursor 36.

The leaders are provided on a traveling direction side of the flexographic printing plate precursor 36, that is, on a leading end 36c (see Fig. 9) on a transport direction D side and a trailing end 36d (see Fig. 9) on an opposite side. The leaders include a leading end leader 62 and the trailing end leader 63 shown in Figs. 9 and 12. Both the leading end and the trailing end of the flexographic printing plate precursor 36 are fixed by the leaders.

As shown in Figs. 9 and 12, for example, a plurality of fixing units 56b are provided on the transport chain 56 at equal intervals along a longitudinal direction of the transport chain 56. The leading end leader 62 and the trailing end leader 63 are fixed to the fixing units 56b. The longitudinal direction of the transport chain 56 is the same direction as the transport direction D.

As shown in Fig. 9, the leading end leader 62 has a long base 62a and a bending portion 62b provided at each end of the base 62a in the longitudinal direction. As shown in Fig. 10, a plurality of attaching portions 62c are provided at the base 62a with gaps at equal intervals along the longitudinal direction of the base 62a. A pin 62d is provided for each attaching portion 62c. The pin 62d is passed through the flexographic printing plate precursor 36, and the flexographic printing plate precursor 36 is fixed to the leading end leader 62. In this case, in order to suppress the movement of the flexographic printing plate precursor 36 during transporting, it is preferable that the base 62a and the leading end of the flexographic printing plate precursor 36 are aligned and fixed.

As shown in Fig. 9, the bending portion 62b of the leading end leader 62 is fixed to the fixing unit 56b of the transport chain 56, and the leading end leader 62 is fixed to the transport chain 56. A method of fixing the leading end leader 62 to the transport chain 56 is not particularly limited, and the leading end leader is fixed to the transport chain through at least one of fixing methods using hooking, screwing, sandwiching, or a magnetic force.

The hooking is, for example, a method of hooking the bending portion 62b to the fixing unit 56b.

The screwing is, for example, a method of fixing the bending portion 62b to the fixing unit 56b using a bolt and a nut. In addition thereto, a method of forming a female thread in the fixing unit 56b and fixing the bending portion 62b to the fixing unit 56b using a screw is also included in screwing.

The sandwiching is, for example, a method of collectively sandwiching and fixing the bending portion 62b and the fixing unit 56b to each other using a member such as a clip.

Fixing by a magnetic force is, for example, a method of forming the bending portion 62b and the fixing unit 56b by magnetic materials and fixing the bending portion 62b and the fixing unit 56b to each other using magnets.

The trailing end leader 63 has basically the same configuration as that of the leading end leader 62 described above. As shown in Fig. 10, the trailing end leader 63 has a long base 63a and a bending portion 63b provided at each end of the base 63a in a longitudinal direction. A plurality of attaching portions 63c are provided at the base 63a with gaps at equal intervals along the longitudinal direction. A pin 63d is provided for each attaching portion 63c. The pin 63d is passed through the flexographic printing plate precursor 36, and the flexographic printing plate precursor 36 is fixed to the trailing end leader 63. In this case, in order to suppress the movement of the flexographic printing plate precursor 36 during transporting, it is preferable that the base 63a and the trailing end of the flexographic printing plate precursor 36 are aligned and fixed. As described above, the pins 62d and 63d are fixing members fixing the flexographic printing plate precursor.

The bending portion 63b of the trailing end leader 63 is fixed to the fixing unit 56b of the transport chain 56, and the trailing end leader 63 is fixed to the transport chain 56. A method of fixing the trailing end leader 63 to the transport chain 56 is not particularly limited, and the trailing end leader is fixed to the transport chain through at least one method of fixing methods using hooking, screwing, sandwiching, or a magnetic force, like the leading end leader 62.

Since the leading end leader 62 is on the traveling direction side, a force acts in a direction in which the fixing unit 56b presses the bending portion 62b of the leading end leader 62 even in a case of being hooked. In order to make a force act in the direction in which the bending portion 62b is pressed, it is necessary to hook the bending portion 63b of the trailing end leader 63 in an opposite direction to the leading end leader 62. For this reason, fixing methods using screwing, sandwiching, and a magnetic force, which allow fixing in states of Figs. 9 and 12, are preferable for the trailing end leader 63.

In addition, transporting tension fluctuates in some cases due to fluctuations of transporting during transporting of the flexographic printing plate precursor 36. Transporting of the flexographic printing plate precursor 36 becomes unstable due to the fluctuations of the transporting tension. In addition, the flexographic printing plate precursor 36 expands and contracts in some cases due to the transporting tension during transporting. For this reason, it is preferable to suppress the fluctuations of the transporting tension and effects of expansion and contraction or the like of the flexographic printing plate precursor 36. Thus, it is preferable for the leader to have a leader mechanism portion 64 that expands and contracts with respect to the traveling direction of the flexographic printing plate precursor 36. The leader mechanism portion 64 can reduce the fluctuations of the transporting tension and the effects of expansion and contraction or the like of the flexographic printing plate precursor 36 by expanding and contracting with respect to the traveling direction of the flexographic printing plate precursor 36.

Since the leading end leader 62 is on the traveling direction side, transporting tension is unlikely to fluctuate, but the transporting tension of the trailing end leader 63 is likely to fluctuate. For this reason, it is preferable for the trailing end leader 63 to have the leader mechanism portion 64 (see Fig. 11).

For example, as shown in Fig. 11, the leader mechanism portion 64 is provided between the base 63a and the flexographic printing plate precursor 36. The leader mechanism portion 64 has a frame material 64a and an elastic member 64b such as a spring and rubber, and the frame material 64a and the base 63a are disposed parallel to each other and are connected to each other by the elastic member 64b. In a case where the leader mechanism portion 64 is provided, the pin 63d is not provided at the base 63a, and the pin 63d (see Fig. 10) is provided at the frame material 64a. The frame material 64a is fixed to the flexographic printing plate precursor 36.

The leading end leader 62 may be configured to have the leader mechanism portion 64. In this case, the leader mechanism portion 64 is provided at the base 62a.

The washout processor 10b is not limited to a form in which the leading end leader 62 and the trailing end leader 63 are attached to one flexographic printing plate precursor 36 as described above, and a plurality of flexographic printing plate precursors may be attached to the leaders. For example, as shown in Fig. 12, a form in which the leading end leader 62 and the trailing end leader 63 are attached to two flexographic printing plate precursors 36 may be adopted. An example in which the two flexographic printing plate precursors 36 are provided as shown in Fig. 12 is merely an example, the flexographic printing plate precursor 36 is not limited to two, a form in which three or more flexographic printing plate precursors 36 are attached may be adopted, and a form in which a plurality of flexographic printing plate precursors 36 are attached as described above can be adopted.

Although the leading end leader 62 and the trailing end leader 63 fix the flexographic printing plate precursor 36 using the pin 62d and the pin 63d respectively, the shapes, numbers, and disposition intervals of the pins 62d and 63d are not particularly limited. It is preferable that the attaching portion 62c provided with the pin 62d and the attaching portion 63c provided with the pin 63d are disposed with a gap for convenience of removing the flexographic printing plate precursor 36. In a case where the pins 62d and 63d fix the flexographic printing plate precursor 36, it is preferable that residues or the like are not generated in order not to contaminate an exposure surface of the flexographic printing plate precursor 36, that is, the front surface 36a or not to contaminate the washing solution Q in the developing tank 54.

In addition, the pins 62d and 63d have, for example, barbs (not shown). Due to the barbs, the flexographic printing plate precursor 36 is unlikely to come off from the pin 62d, and the flexographic printing plate precursor 36 is reliably fixed. For this reason, it is preferable that the pins 62d and 63d have barbs. The barb is a protruding portion of the pin 62d. The barb makes the flexographic printing plate precursor 36 unlikely to come off from the pin 62d.

In addition, it is preferable that surfaces of the pins 62d and 63d brought into contact with at least the flexographic printing plate precursor 36 have a resin layer, a plating layer, or a diamond-like carbon layer (DLC layer) or a plurality of uneven portions are formed on the surfaces brought into contact with the flexographic printing plate precursor 36.

A hard chrome plating layer is preferable as the plating layer. In addition thereto, surface treatment with titanium nitride (TiN) or the like may be performed on the surfaces of the pins 62d and 63d brought into contact with the flexographic printing plate precursor 36. Accordingly, friction between the pins 62d and 63d and the flexographic printing plate precursor 36 is reduced, and the pins 62d and 63d are likely to be passed through the flexographic printing plate precursor 36. Further, the durability of the pins 62d and 63d improves, the pins 62d and 63d can be repeatedly used, and the durability of the leading end leader 62 and the trailing end leader 63 also improves.

The plurality of uneven portions of the surfaces of the pins 62d and 63d brought into contact with the flexographic printing plate precursor 36 are formed through, for example, embossing.

In the washout processor 10b, the development unit 51 and the rinsing unit 52 are provided along the transport path Dp for the flexographic printing plate precursor 36. For example, the development unit 51 is provided in the developing tank 54, and the rinsing unit 52 is provided at an upper portion of the developing tank 54 where the flexographic printing plate precursor 36 that has gone via the development unit 51 first comes out. That is, the rinsing unit 52 is provided at an upper portion of the second tank portion M₂.

The rinsing unit 52 is provided on the downstream side of the development unit 51 in the traveling direction of the flexographic printing plate precursor 36. Herein, the downstream side is a side in a direction in which the leading end 36c (see Fig. 9) of the flexographic printing plate precursor 36 advances in a case of transporting the flexographic printing plate precursor 36. In addition, downstream is a destination where the leading end 36c (see Fig. 9) advances in the transport direction D of the flexographic printing plate precursor 36. An opposite side of the downstream side is an upstream side.

Further, the washout processor 10b has a waste liquid tank 65 provided at the developing tank 54 via a connecting pipe 65a as shown in Fig. 6. The washing solution Q overflowing the developing tank 54 or a fatiqued developer Qw, which is the developed washing solution Q, is transferred to the waste liquid tank 65 through the connecting pipe 65a.

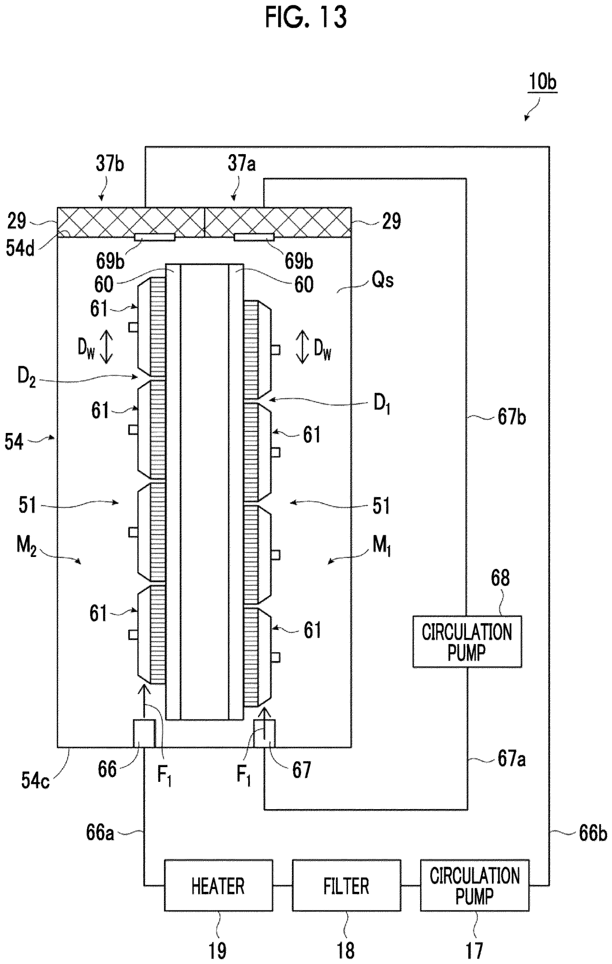

In addition, a supply port 66 is provided in a side surface 54c of the developing tank 54 on a side where the rinsing unit 52 is provided. The supply port 66 is connected to the heater 19 via a pipe 66a. In addition, as shown in Fig. 13, the filter 29 is provided at a side surface 54d of the developing tank 54 to face the supply port 66. A pipe 66b is provided via the filter 29. The pipe 66b is connected to the circulation pump 17.

A second flow creation unit 37b that flows the washing solution Q in the second tank portion M₂ in the intersecting direction to cross the width Ws of the flexographic printing plate precursor 36 is composed of the circulation pump 17, the filter 18, the heater 19, the filter 29, the supply port 66, and the pipe 66b.

In addition, a supply port 67 is provided in the side surface 54c of the developing tank 54 on a side where the rinsing unit 52 is not provided. The supply port 67 is connected to a circulation pump 68 via a pipe 67a. The filter 29 is provided at the side surface 54d of the developing tank 54 to face the supply port 67. The filter 29 is provided with a pipe 67b. The pipe 67b is connected to the circulation pump 68. A first flow creation unit 37a that flows the washing solution Q in the first tank portion M₁ in the intersecting direction to cross the width Ws of the flexographic printing plate precursor 36 is composed of the supply port 67, the pipe 67a, and the circulation pump 68.

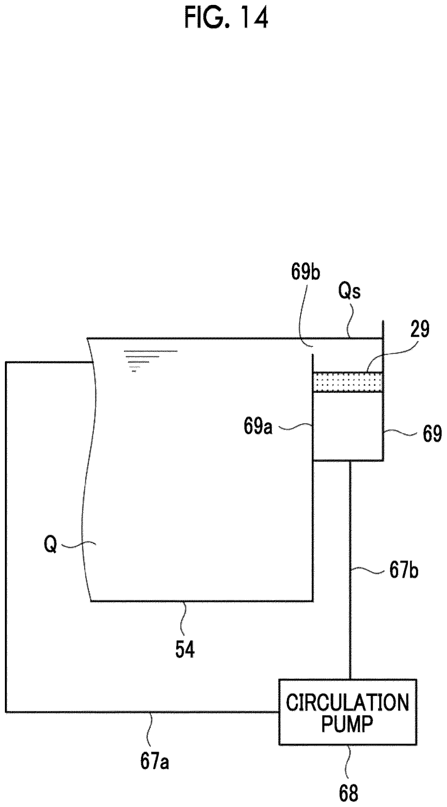

As shown in Fig. 14, the filter 29 is provided at a tank 69 provided continuously to the developing tank 54. A partition plate 69a between the developing tank 54 and the tank 69 is lower than the liquid level Qs of the washing solution Q, and the overflowing washing solution Q moves to the tank 69. For this reason, in a case where solid contents float on the liquid level Qs, the solid contents are moved to the tank 69 and are captured by the filter 29, the washing solution Q from which the solid contents are removed, that is, a regenerated washing solution is transferred to the circulation pump 68. The circulation pump 68 is a supply unit that supplies the washing solution Q from which a non-exposed portion is removed by the filter 29 to the developing tank 54, and a pump that transfers a known liquid is usable as appropriate. An upper portion of the partition plate 69a is an overflow port 69b. The circulation pump 68 corresponds to the supply unit that supplies the washing solution Q from which the non-exposed portion is removed to the developing tank 54.

### (Transporting Unit)

In the transporting unit 50, the gear 55 is rotated by the transport driving unit 57, and the flexographic printing plate precursor 36 fixed to the transport chain 56 using the leading end leader 62 and the trailing end leader 63 moves in the vicinity of the frame 53. The transport path Dp for the flexographic printing plate precursor 36 is a path for going around the vicinity of the frame 53 and has the curved transport passage Dpc and the linear transport passage Dps.

In the washout processor 10b, for example, after one time of development, processing by the rinsing unit 52 is performed and ended. A rinsing step is performed after the developing step of performing development. However, development is not limited to one time, and the flexographic printing plate precursor 36 may go around the vicinity of the frame 53 a plurality of times in order to perform development a plurality of times.

Although there are various transport paths such as a one-direction transport path, a reciprocating transport path, and a go-around transport path as the transport path Dp for the flexographic printing plate precursor 36, it is preferable that the transport path Dp for the flexographic printing plate precursor 36 is the one-direction transport path or the go-around transport path since processing by the rinsing unit 52 is necessary after development.

### (Development Unit)

Insofar as a non-exposed portion (not shown) of the flexographic printing plate precursor 36 can be removed and developed, the configuration of the development unit 51 is not particularly limited and is not limited to development using the brush 61 to be described later. The configuration of the brush is also not particularly limited, and a rotary brush and a brush having a rotation axis parallel to the nip roll can also be used in addition to the configuration of the brush 61 to be described later. In this case, a roller-shaped brush in which bristles are bundled radially with respect to a rotation axis can be used. In the development unit 51, the configuration of the brush, the number of brushes, and the like are not particularly limited.

The development unit 51 develops the flexographic printing plate precursor 36 using the washing solution Q stored in the developing tank 54. Development is performed on the flexographic printing plate precursor 36 in a state of being immersed in the washing solution Q in the developing tank 54 and being transported.

In the development unit 51, the fatiqued developer Qw is generated in the developing tank 54 due to development by the brush 61. The fatiqued developer Qw is the washing solution Q containing solid contents generated by removing the non-exposed portion (not shown) of the flexographic printing plate precursor 36 due to development using the washing solution Q.

The flexographic printing plate precursor in a state where the non-exposed portion is removed due to development is referred to as a developed flexographic printing plate precursor.

### (Development Unit)

The driving unit rotates the brush 61 in a state where the rotation axis C of the brush 61 passes through the front surface 36a of the flexographic printing plate precursor 36. The driving unit moves the rotation axis C of the brush 61 in at least one direction intersecting the rotation axis C. The rotation of the brush 61 and the movement of the brush 61 are controlled by the driving unit unless stated otherwise.

As shown in Fig. 13, the brush 61 is disposed on a front surface 36a side of the flexographic printing plate precursor 36, and for example, the direction Dw orthogonal to the transport direction D is set as a first moving direction of the brush 61, which intersects the rotation axis C. The brush 61 is configured to move in the direction Dw. In addition, the brush 61 may be configured to be moved in two directions with respect to the rotation axis C. In a case of being moved in two directions, the two directions are not particularly limited insofar as the brush is moved in two directions, may be two directions intersecting the rotation axis C, or may be two directions orthogonal to the rotation axis C. Specifically, for example, the first moving direction is the direction Dw, and a second moving direction is the transport direction D. Insofar as the brush 61 can uniformly rub the entire front surface 36a of the flexographic printing plate precursor 36, the moving directions of the brush 61 are not particularly limited. Insofar as the brush 61 is configured to be moved in two directions orthogonal to each other, the entire front surface 36a of the flexographic printing plate precursor 36 can be uniformly rubbed by the brush 61, and development uniformity improves. Further, the development speed also improves by moving the brush 61 in the two directions orthogonal to each other.

In a case where the four brushes 61 are arranged along the transport direction D of the flexographic printing plate precursor 36, it is preferable to change at least one of a density at which bristles are planted or the thickness of the bristles in the first brush 61 and the second brush 61. While development proceeds even with the same processing time with a brush having high-density or thick bristles, a finished state related to print quality, such as independent small dots, deteriorates in some cases. Thus, in a case of disposing two or more brushes 61 in the transport direction D, it is preferable to first dispose a type of brush that makes development progress quickly and to dispose a type of brush that is excellent in development treatment quality as a brush in the latter half of the development.

### <Brush>

The brush 61 performs development by removing a non-exposed portion (not shown) of the flexographic printing plate precursor 36. For example, the brush 61 is immersed in the washing solution Q and is disposed on the front surface 36a side of the flexographic printing plate precursor 36 in the transport direction D in the developing tank 54. In a state where the flexographic printing plate precursor 36 is transported, the front surface 36a of the flexographic printing plate precursor 36 is rubbed as the brush 61 is rotated in the rotation direction r (see Fig. 13) by the driving unit, and development is performed by removing the non-exposed portion (not shown) of the flexographic printing plate precursor 36. During the development, the fatiqued developer Qw described above is generated.

Since the brush 61 is disposed by being immersed in the washing solution Q, the washing solution Q attached to the brush 61 is not dried, and it is suppressed that the non-exposed portion or the like removed by the brush 61 is fixed to the brush 61 as development residues.

The area of the brush 61, which is obtained by projecting the brush 61 onto the front surface 36a of the flexographic printing plate precursor 36, is smaller than the area of the front surface 36a of the flexographic printing plate precursor 36. For this reason, the brush 61 is partially applied with respect to the entire width of the flexographic printing plate precursor 36 and performs development. During development, since the brush 61 is small, the brush 61 moves, for example, in the transport direction D and the direction Dw as described above in order for the brush 61 to uniformly rub the entire front surface 36a of the flexographic printing plate precursor 36, but may be configured to move only in the direction Dw.

A moving path of the brush 61 is determined in advance according to the size of the brush 61, the size and the transportation speed of the flexographic printing plate precursor 36, or the like. Accordingly, the moving path of the brush 61 is programmed in the driving unit, and the driving unit can move the brush 61 along the moving path to perform development based on a program.

The brush 61 is obtained, for example, by bundling bristles perpendicular to a substrate and has the same configuration as the brush 41 described above. The shape of the substrate is the shape of the brush 61. For example, the substrate is circular, but is not particularly limited thereto.

The rotation shaft portion is provided on the substrate. Accordingly, the rotation axis C is provided in the brush 61. In addition, by adjusting a position where the rotation shaft portion is provided, the position of the rotation axis C can be adjusted in the brush 61. The rotation shaft portion can also be provided at a place other than the center of the substrate, but in this case, the brush 61 moves eccentrically.

Herein, the center of the brush 61 is the center of the substrate of the brush 61, that is, the geometric center of a shape obtained by projecting the substrate onto a plane. In a case where the substrate is circular, the center of the circle is the center of the brush 61. In a case where the substrate is rectangular, a point where diagonals of the rectangle intersect each other is the center of the brush 61.

The expression that the rotation axis C of the brush 61 passes through the center of the brush 61 means that the rotation shaft portion 61a is disposed such that the rotation axis C passes through the center of the substrate in a case where the substrate is circular. As the rotation axis C is disposed to pass through the center of the brush 61, the brush 61 can be uniformly brought into contact with the front surface 36a of the flexographic printing plate precursor 36. For this reason, development uniformity improves.

In addition, as the rotation axis C is disposed to pass through the center of the brush 61, the brush 61 rotates stably in a case where the brush 61 spins. For this reason, the brush can be stably rotated even in a case where the number of rotations is increased in order to increase the rotation speed of the brush 61. Accordingly, the development speed can be increased.

In addition, in a case where the plurality of brushes 61 are disposed in juxtaposition, contact between the brushes 61 can be suppressed even in a case where an interval between the brushes 61 is decreased. For this reason, the rotation axis C of the brush 61 preferably passes through the center of the brush 61.

For example, a brush called a cup brush is used as the brush 61. It is preferable that the bristles of the brush 61 are used by being applied substantially perpendicular to the front surface 36a of the flexographic printing plate precursor 36.

The brush 61 is smaller than the flexographic printing plate precursor 36 as described above. As the brush 61 is small, the brush 61 is moved and performs development on the flexographic printing plate precursor 36, the pressure of the brush 61 can be made uniform, and development uniformity can be improved.

Further, since a brush area necessary for development can be reduced as the brush 61 performs development by moving in a plane direction while the flexographic printing plate precursor 36 is transported, the washout processor can be simplified.

The size of the brush 61 is not particularly limited insofar as the brush is smaller than the flexographic printing plate precursor 36. In a case where the outer shape of the substrate of the brush 61 is circular, the diameter DB (see Fig. 8) thereof is preferably 30 mm to 500 mm, the diameter DB is more preferably 100 to 400 mm, and the diameter DB is most preferably 200 to 400 mm.

In a case where the shape of the substrate of the brush 61 is a brush shape other than a circle, a diameter equivalent to the circle, that is, a diameter corresponding to the brush area is used as the diameter in a case where the outer shape of the substrate described above is circular.

In addition, the brush 61 rotates and performs development, but the number of rotations of the brush 61 is preferably 10 revolutions per minute (rpm) to 2,000 rpm, more preferably 20 to 800 rpm, and even more preferably 30 to 200 rpm.

By increasing the number of rotations of the brush 61 and increasing the rotation speed, the development speed can be increased as described above, and development uniformity also improves.

Herein, as for a mechanism of adhesion of development residues, it is estimated that development residues are deposited in the brush 61 and are transferred and attached to the flexographic printing plate precursor 36 at a certain timing during development. For this reason, it is necessary to efficiently discharge the development residues from the inside of the brush 61 to the outside of the brush 61. Thus, in a case where the number of rotations of the brush 61 is high, the washing solution in the brush 61 is likely to be discharged to the outside of the brush 61 due to rotation, and development residues in the brush 61 can be efficiently discharged to the outside of the brush 61.

In addition, the number of rotations of the brush 61 is not limited to being a fixed value and may be variable. In a case where the number of rotations of the brush 61 is variable, for example, the number of rotations is determined in advance from the initial stage of development to the end of development, and development can also be performed at the determined number of rotations.

The substrate of the brush 61 holds the bristles, and for example, the bristles are implanted in a bundle. Insofar as the substrate can hold the bristles and does not become deteriorated due to the washing solution Q, there is no particular limitation.

The material for the bristles of the brush 61 is not particularly limited. For example, natural fibers, such as coir, and any material that can be made into a fibrous form, such as a metal, polyamide, polyester, vinyl chloride, vinylidene chloride, polyimide, and polyacrylonitrile, are suitably used.

The fiber diameter of each bristle of the brush is preferably approximately 10 µ to 1 mm and may be implanted in a bundle or be independently implanted within several bristles. The implanting interval is preferably approximately 1 to 20 mm, and in a case of being implanted in a bundle, the diameter of the bundle is preferably approximately 1 to 10 mm. In addition, the length of each of the bristles of the brush is preferably approximately 2 to 50 mm and more preferably 5 to 25 mm. In a case where the length of each of the bristles of the brush is 5 to 25 mm, the leading end leader 62 and the trailing end leader 63 for transport can be passed through, a brush force becomes strong so that independent small dot performance is obtained, and a development speed thereof also increases.

The length of each of the bristles may vary in one brush 61, and it is preferable that bristles in a central portion are long. In addition, the thickness of each of the bristles in one brush 61 may vary, or the density of the bristles in one brush 61 may vary.

In addition, in a case where bristles obtained by adding a fine abrasive material such as alumina or silicon carbide to a nylon thread are used as a material for the bristles of the brush disposed on a first region Di side, the development speed in the first half of development can be increased, and a development treatment time can be shortened. As the bristles to which the abrasive material is added, wavy bristles, which are not uncurled bristles and which are called curly bristles, can be used rather than straight bristles. Since the abrasive material is contained, abrasion of the brush can be reduced, and the brush life can be extended. Examples of a commercially available bristle material include Sungrid (product name) manufactured by Asahi Kasei Corporation, Tragrid (product name) manufactured by Toray Industries, Inc., and Tynex (product name) manufactured by DuPont. On the other hand, in a case of the brush disposed on a second region D₂ side, there is a possibility that scratches are generated on the flexographic printing plate precursor 36 depending on a type of an abrasive material, and the abrasive material may be used properly according to the region of the flexographic printing plate precursor 36.

The bristles of the brush 61 are bundled on the substrate. The bristles are provided in a region other than a region where a radius with respect to the center of the substrate is within 10 mm. That is, it is preferable that the bristles are not provided in a region where a radius with respect to the rotation axis C is 10 mm, and the bristles are preferably provided in a region other than the region. As described above, it is preferable that in the brush 61, the bristles are not provided in the region where the radius with respect to the rotation axis C is within 10 mm, and the bristles are provided in a region where the radius exceeds 10 mm.

In a case where the bristles are provided in the region of the brush 61 in the region where the radius is within 10 mm, development residues are likely to be discharged, the rotation speed also increases, and independent small dot performance is obtained during development, which is preferable.

In order to maintain the development speed of the brush 61, it is preferable that the bristles are provided in a region of 30% or more of the substrate. The fact that the bristles are provided in an area of 30% or more of the substrate of the brush 61 means that the area of the bristles is 30%.

As described above, the brush 61 is rotated by the driving unit in a state where the rotation axis C of the brush 61 passes through the front surface 36a of the flexographic printing plate precursor 36. In this case, in a case where an angle formed by the rotation axis C with respect to the front surface 36a of the flexographic printing plate precursor 36 is set as θ, the angle θ is preferably 30° ≤ θ ≤ 90°, more preferably 45° ≤ θ ≤ 90°, and most preferably 60° ≤ θ ≤ 90°. By setting the angle θ to 60° ≤ θ ≤ 90°, the brush 61 can be uniformly brought into contact with the front surface 36a of the flexographic printing plate precursor 36, and development can be performed even in a case where the pressure of the brush 61 is increased. For this reason, both the development uniformity and the development speed can be increased. As described above, it is most preferable that the rotation axis C of the brush 61 is perpendicular to the front surface 36a of the flexographic printing plate precursor 36.

The angle θ can be obtained as follows. First, an image of a state where the brush 61 is disposed on the front surface 36a of the flexographic printing plate precursor 36 is acquired, and a line corresponding to the rotation axis C of the brush 61 and a line corresponding to the front surface 36a of the flexographic printing plate precursor 36 are acquired from the image. Next, an angle formed by the two lines is acquired. Accordingly, the angle θ can be obtained.

A state where the rotation axis C of the brush 61 passes through the front surface 36a of the flexographic printing plate precursor 36 means passing through the front surface 36a of the flexographic printing plate precursor 36 or a surface obtained by expanding the front surface 36a of the flexographic printing plate precursor 36 in a case of the rotation axis C or in a case where the rotation axis C is extended, and shows a disposition relationship between the brush 61 and the flexographic printing plate precursor 36.

For this reason, the rotation axis C of the brush 61 does not pass through the actual front surface 36a of the flexographic printing plate precursor 36 in some cases depending on the inclination of the rotation axis C, but the rotation axis C of the brush 61 is not limited to actually passing through the front surface 36a of the flexographic printing plate precursor 36 as described above.

The position of the brush 61 with respect to the front surface 36a of the flexographic printing plate precursor 36 may be fixed. In addition, a configuration where the brush approaches or is spaced apart from the front surface 36a of the flexographic printing plate precursor 36 may be adopted. As the brush 61 can approach or be spaced apart from the front surface 36a of the flexographic printing plate precursor 36, the pressure of the brush 61 can be adjusted with respect to the front surface 36a of the flexographic printing plate precursor 36. Accordingly, the pressure of the brush 61 can be increased, and the development speed can be improved.

In a case where the pressure of the brush 61 is increased with respect to the front surface 36a of the flexographic printing plate precursor 36, it is preferable that the material for the bristles of the brush 61, the length of each bristle, the thickness of each bristle, or the like corresponds to the pressure. The bristles of the central portion in one brush 61 may be made long, the thickness of each of bristles in one brush 61 may be changed, or the density of the bristles in one brush 61 may be changed.

In addition, as the brush 61 can be spaced apart from the front surface 36a of the flexographic printing plate precursor 36, the brush 61 can be lifted from the front surface 36a of the flexographic printing plate precursor 36. Accordingly, in a case where development residues of the brush 61 are attached, the development residues can be removed from the brush 61.

As for the operation of the brush 61, the brush 61 may move at all times during development, or the brush 61 may rotate only in a case where the flexographic printing plate precursor 36 is transported to the developing tank 54. In this case, for example, a sensor (not shown) that detects the flexographic printing plate precursor 36 is provided above the developing tank 54, a time when the brush 61 is reached is identified using a transport timing and the transportation speed of the flexographic printing plate precursor 36, and development can be performed by rotating the brush 61.

In addition, for example, the outside of the flexographic printing plate precursor 36 and the upper side of the front surface 36a of the flexographic printing plate precursor 36 can be used as a retracting place for the brush 61. The driving unit moves the brush 61 to the retracting place, and the driving unit causes the brush 61 to retract from the flexographic printing plate precursor 36. By retracting the brush 61 from the flexographic printing plate precursor 36, attachment of development residues is suppressed, which is preferable.

In a case where the retracting place for the brush 61 is outside the flexographic printing plate precursor 36, the development residues are unlikely to be attached to the front surface 36a of the flexographic printing plate precursor 36 again, and attachment of the development residues can be further suppressed compared to a case where the brush 61 is retracted by being simply lifted from the front surface 36a of the flexographic printing plate precursor 36.

In a case of removing the development residues, in addition to moving the brush 61 to the retracting place, retracting conditions such as a development time and a development treatment area are set, and in a case where the retracting conditions are satisfied, the brush 61 may be configured to be moved to the retracting place. In this case, for example, the sensor (not shown) that detects the flexographic printing plate precursor 36 is provided above the developing tank 54, the retracting conditions are set in the driving unit, the input amount of the flexographic printing plate precursor 36 is identified using the transport timing and the transportation speed of the flexographic printing plate precursor 36, and the retraction of the brush 61 can be controlled.

In addition, in order to efficiently discharge the development residues in the brush 61 to the outside of the brush 61, the washing solution may be supplied to the brush 61 at the retracting place for the brush 61, and the development residues may be discharged to the outside of the brush 61.

### (Rinsing Unit)

The rinsing unit 52 removes residues, such as latex components and rubber components remaining on the front surface 36a of the developed flexographic printing plate precursor 36 carried out from the development unit 51, using a rinsing liquid such as a washing solution. Removing residues, such as latex components and rubber components remaining on the front surface 36a of the flexographic printing plate precursor 36, using a rinsing liquid such as a washing solution, by the rinsing unit 52 is called the rinsing step.

The developed flexographic printing plate precursor 36 is transported from the development unit 51, is transported to the outside of the developing tank 54, and is processed by the rinsing unit 52.

The rinsing unit 52 has a rinsing liquid supply unit 52a and a liquid drain nozzle 52b. Since the rinsing liquid supply unit 52a and the liquid drain nozzle 52b have the same configurations of the rinsing liquid supply unit 47a and the liquid drain nozzle 47b shown in Fig. 4, respectively, detailed description thereof will be omitted.

The rinsing unit 52 applies a rinsing liquid, for example, from the rinsing liquid supply unit 52a to the front surface 36a of the developed flexographic printing plate precursor 36, for example, in a spray-like manner, washing away the residues described above. The fatiqued developer Qw supplied from the rinsing liquid supply unit 52a and the residues, which are washed away and are described above, accumulate in the developing tank 54.

It is preferable that the rinsing unit 52 is provided such that the rinsing liquid is supplied to a liquid film generated by the washing solution remaining on the developed flexographic printing plate precursor 36 carried out from the development unit.

For a reason that the liquid film generated by the washing solution is likely to flow into the developing tank 54 together with the rinsing liquid, a position to which the rinsing liquid is supplied is preferably 50 cm or lower, is more preferably 30 cm or lower, and is even more preferably 15 cm or lower from the liquid level Qs of the washing solution Q.

For example, in Fig. 6, the position where the rinsing liquid is supplied is a position 10 cm from the liquid level.

As the used rinsing liquid supplied from the rinsing unit 52 flows into the developing tank 54, a total waste liquid amount can be reduced. In particular, in a case where the transport path is in an up-down direction, an effect of reducing the waste liquid amount is great. For this reason, it is preferable that the used rinsing liquid flows into the developing tank 54 also in the rinsing step.

The rinsing liquid supply amount of the rinsing liquid supplied for each unit area of the flexographic printing plate precursor to which the rinsing liquid is supplied is preferably sprayed at 0.3 to 7 kg/m² and more preferably at 0.5 to 4 kg/m². As the rinsing liquid supply amount described above is set to 0.3 kg/m² or more, the residues described above, which remain on the front surface 36a of the developed flexographic printing plate precursor 36, can be stably washed away. On the other hand, as the rinsing liquid supply amount described above is set to 7 kg/m² or less, the inflow amount of the rinsing liquid into the developing tank 54 is reduced, and the waste liquid amount can be reduced.

As the rinsing liquid, the washing solution Q to be supplied may be the washing solution Q newly prepared in another tank (not shown).

### <Washing Method>

A washing method of the washout processor 10b will be described.

First, the front surface 36a of the flexographic printing plate precursor 36 is imagewise exposed, that is, exposed in a specific pattern by the exposure device (not shown).

In the washout processor 10b, for example, the leading end leader 62 is fixed by being hooked or the like to the fixing units 56b of the pair of transport chains 56 respectively. For example, the trailing end leader 63 is fixed to the fixing units 56b of the transport chains 56 using a magnet. Accordingly, the leading end leader 62 and the trailing end leader 63 are transported in the transport passage by the transporting unit 50.

The leading end of the flexographic printing plate precursor 36 is fixed to the leading end leader 62, and the trailing end is fixed to the trailing end leader 63. In a state where the flexographic printing plate precursor 36 is fixed to the leading end leader 62 and the trailing end leader 63, the turn bar 59a is raised from a lowered state, and tension is applied to the flexographic printing plate precursor 36. As described above, the flexographic printing plate precursor 36 is fixed to the leaders, and a force acts in the direction in which the length of the flexographic printing plate precursor 36 extends in a state where the flexographic printing plate precursor 36 is fixed to the leaders. After fixing the flexographic printing plate precursor 36, tension applied to the flexographic printing plate precursor 36 is made higher than tension applied to the flexographic printing plate precursor 36 in a case of fixing the flexographic printing plate precursor 36.

Next, the flexographic printing plate precursor 36 is transported along the transport path Dp. In a state where the flexographic printing plate precursor 36 is immersed in the washing solution Q and is transported, the brush 61 of the development unit 51 performs development by removing a non-exposed portion of the flexographic printing plate precursor 36. Since the operations of the brushes 61 are as described above, detailed description thereof will be omitted. In the developing step, the fatiqued developer Qw is generated.

Then, the flexographic printing plate precursor 36 is carried out from the second tank portion M₂ of the developing tank 54. In a state where the flexographic printing plate precursor 36 is transported, a rinsing liquid is applied to the front surface 36a of the flexographic printing plate precursor 36 by the rinsing unit 52, and residues on the front surface 36a are removed. In a case of performing development once, at this time point, the fixing of the leading end leader 62 and the trailing end leader 63 is released, and the flexographic printing plate precursor 36 is removed from the leading end leader 62 and the trailing end leader 63. In a case of performing development a plurality of times, the flexographic printing plate precursor 36 is transported by going around, and the flexographic printing plate precursor 36 enters the first tank portion M₁ of the developing tank 54 again so that development is performed. Until a predetermined number of times is reached, the developing step and the rinsing step are performed repeatedly. In this case, in at least one of the first tank portion M₁ or the second tank portion M₂, preferably the second tank portion M₂, the washing solution Q is flowed in a direction intersecting the width of the flexographic printing plate precursor 36. That is, the washing solution Q is flowed in the direction F₁ (see Fig. 13). Accordingly, attachment of solid contents to the front surface 36a of the flexographic printing plate precursor 36 is suppressed.

In a case where the flexographic printing plate precursor 36 goes around a plurality of times, even in a state where the attachment of the solid contents to the front surface 36a of the flexographic printing plate precursor 36 is suppressed in the second tank portion M₂, a probability of the solid contents being attached to the flexographic printing plate precursor 36 is high in a case where the solid contents float on the liquid level of the first tank portion M₁. For this reason, it is preferable to flow the washing solution Q in the direction F₁ (see Fig. 13) in both the first tank portion M₁ and the second tank portion M₂.

In addition, in the washout processor 10b, even in a case where the concentration of solid contents in the washing solution Q of the developing tank is 6.3%, solid substances are not attached to the flexographic printing plate precursor 36. Further, in this state, in a case where development treatment is continued, an aggregate on the liquid level Qs of the washing solution Q is efficiently removed by the filter 29 provided at the overflow port 69b. For this reason, the concentration of the solid contents in the washing solution Q has decreased, for example, from 6.3% to 4.8%. The filter 29 of the overflow port 69b is recognized to have effects such as reducing a load on the filter 18 provided at a discharge destination of the circulation pump 17 and lowering the concentration of the solid contents dispersed in the washing solution Q.

By setting the transport path Dp that goes around the vicinity of the frame 53 as in the washout processor 10b, a provision area can be decreased compared to a transport path through which the flexographic printing plate precursor 36 is transported in one direction.

By changing the sizes of the member 53a (see Fig. 7) and the beam member 53b (see Fig. 7) of the frame 53 (see Figs. 6 and 7), it is possible to correspond to the size of the flexographic printing plate precursor 36. Even in a case where the flexographic printing plate precursor 36 is large, the configuration of the washout processor 10b does not become complicated.

Further, by making the frame 53 in an upright state as shown in Fig. 6 and configuring the flexographic printing plate precursor 36 to be transported perpendicularly to the liquid level of the washing solution Q in the developing tank 54, a grounding area can be decreased compared to a state where the frame 53 is rotated 90° from the state shown in Fig. 6, and the space can be saved. In addition, even in a case where the transport path Dp is long, without increasing the washout processor 10b in size, the grounding area can be decreased, and the space can be saved. In a case of developing the flexographic printing plate precursor 36 in a state where the frame 53 is rotated 90° from the state shown in Fig. 6, it is necessary to increase a region immersed in the washing solution Q, and it is necessary to increase the developing tank 54 as well. However, even in the state where the frame 53 is rotated 90° from the state shown in Fig. 6, the volume of the washout processor 10b is small. For this reason, the washout processor 10b has a small device configuration regardless of the disposition state of the frame 53, and the space can be saved.

In addition, transporting the flexographic printing plate precursor 36 perpendicularly to the liquid level of the washing solution Q in the developing tank 54 is called vertical transport.

Further, in a case of removing the flexographic printing plate precursor 36 from the leading end leader 62 and the trailing end leader 63, a configuration of being removed from the pins 62d and 63d is adopted, and there is no buckling. In addition, since an adhesive layer is not used even in a case where the flexographic printing plate precursor 36 is immersed in the washing solution Q, processing such as development can be stably performed on the flexographic printing plate precursor without being detached.

In a state where the flexographic printing plate precursor 36 is fixed to the leading end leader 62 and the trailing end leader 63 and tension is applied by the tension applying unit, development is performed using the washing solution while transporting the flexographic printing plate precursor. For this reason, fluctuations in the tension of the flexographic printing plate precursor 36 are suppressed, development treatment can be performed in a state where the tension is stable, and processing such as development can be stably performed on the flexographic printing plate precursor 36.

By providing the leader mechanism portion 64 that expands and contracts in the traveling direction of the flexographic printing plate precursor 36, development treatment can be performed in a state where tension is more stable. Accordingly, processing such as development can be more stably performed on the flexographic printing plate precursor.

In the washout processor 10b, the flexographic printing plate precursor 36 is transported using the transport chain 56, and maintainability is excellent without having a complicated device configuration.

In addition, by performing the developing step in a state where the flexographic printing plate precursor 36 is being transported, the brush can be decreased in size, and washing productivity can be improved. It is necessary for the method of the related art in which the printing plate is fixed and only a brush is movable to prepare the brush having a wide area corresponding to the size of the printing plate, to increase the number of brushes in a case of using a small brush, or to increase the operating range of the brush. In a case where the printing plate precursor is transported, even the small brush can obtain the same processing capacity. Further, it is possible to provide more brushes in the linear transport passage Dps in a treatment liquid (not shown) and the curved transport passage Dpc (turn portion), it is possible to increase the transportation speed of the printing plate precursor since a processing time is shortened by an increase in the number of brushes, and the productivity of the washout processor 10b improves.

In addition, by developing the flexographic printing plate precursor 36 in the washing solution Q, it is suppressed that development residues are fixed to the brush 61, and the frequency of maintenance can be decreased. Accordingly, a maintenance load can be decreased, and thus the washout processor 10b is excellent in maintainability.

Since the frequency of maintenance can be decreased, for example, monthly average or annual average development treatment can be increased, and the washout processor 10b has high productivity from this point as well.

As described above, even in the washing solution having a large amount of solid contents, development treatment can be performed without attachment of residues to the flexographic printing plate precursor 36. As a result, the amount of a replenishment liquid such as tap water and a detergent replenishment diluent can be reduced, the number of times of mother liquor exchange can be reduced, and a washout processor with a small environmental load with reduced total waste can be realized.

As a relationship between the concentration of the solid contents and the waste liquid amount of the developer, the waste liquid amount is reduced, and thus running costs are reduced in a case where attachment of residues does not occur even at a high concentration of solid contents.

For example, the concentration of solid contents of the developing tank during development treatment, in which 0.5% dishwasher detergent finish is used, replenishment water is 7.0 L/m², and a scraping amount of the non-exposed portion of the flexographic printing plate precursor is 450 g/m², becomes 5.8% (concentration of solid contents is 6.3% including detergent solid contents). Further, even in a case where the residues are 11.5% (12.0% including the detergent solid contents) and can be prevented from being attached to the flexographic printing plate precursor, the amount of the replenishment water can be reduced to 3.3 L/m². Accordingly, 3.7 L/m² of waste liquid can be reduced, and reduction of an environmental load and reduction of running costs can be realized.

On the other hand, in a case where the concentration of the solid contents exceeds 5.0% (the concentration of the solid contents is 5.5% including the detergent solid contents) and a state where the residues are attached to the flexographic printing plate precursor on which development treatment is performed is caused, it is necessary to entirely replace the liquid of the developing tank with a new liquid and to perform cleaning, and a total waste amount significantly increases, but such a situation does not occur in the washout processor.

### (Fourth Example of Washout Processor)

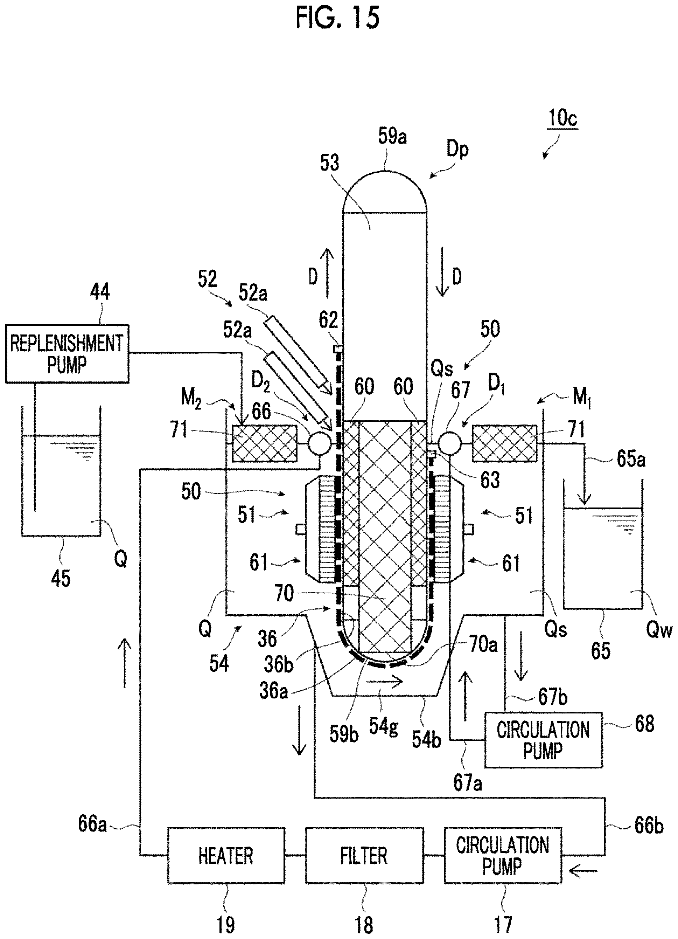

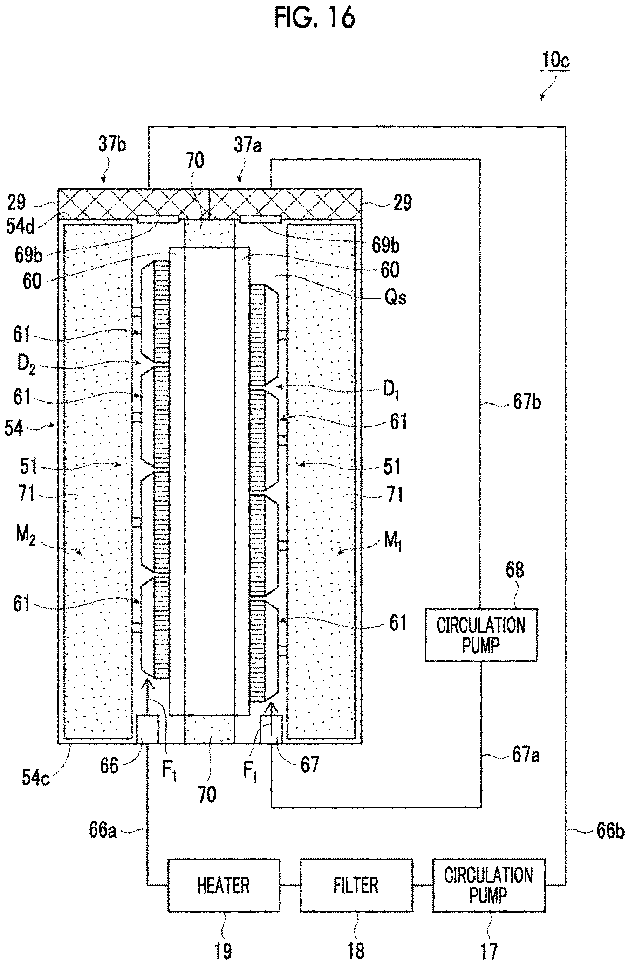

Fig. 15 is a schematic side view showing a fourth example of the washout processor according to the embodiment of the present invention. Fig. 16 is a schematic plan view showing the fourth example of the washout processor according to the embodiment of the present invention.

In Figs. 15 and 16, the same components shown in Figs. 6 to 14 will be assigned with the same reference numerals, and detailed description thereof will be omitted.

A washout processor 10c shown in Figs. 15 and 16 is different from the washout processor 10b shown in Figs. 6 and 13 in terms of the configuration of the developing tank 54 and provision of a partition member 70 and a restricting member 71, and the other configurations are the same as configurations of the washout processor 10b shown in Figs. 6 and 13.

The washout processor 10c is provided with the partition member 70 along the frame 53, in the developing tank 54. With the partition member 70, a space 54g between a bottom surface 54b of the developing tank 54 and an end part 70a of the partition member 70 is divided into a side where the flexographic printing plate precursor 36 enters the washing solution Q and a side where the flexographic printing plate precursor 36 is discharged from the washing solution Q. That is, the developing tank 54 is configured such that the first tank portion M₁ and the second tank portion M₂ communicate with each other in the space 54g due to the partition member 70. For this reason, in the developing tank 54, solid contents floating on the liquid level of the first tank portion M₁, which is the side where the flexographic printing plate precursor 36 enters the washing solution Q, are prevented from moving to the liquid level of the second tank portion M₂, which is the side where the flexographic printing plate precursor 36 is discharged from the washing solution Q. Accordingly, the second tank portion M₂ can maintain a state where the amount of the solid contents is relatively small compared to the first tank portion M₁. The washing solution Q can pass through the space 54g of the developing tank 54 as described above.

A material for the partition member 70 is not particularly limited, and examples thereof include a vinyl chloride resin block, a polyethylene resin block, a polypropylene resin block, a foamed molded body, or the like.

In addition, the second tank portion M₂ is replenished with the washing solution Q by the replenishment pump 44. Accordingly, the washing solution Q stored in the developing tank 54 passes through the space 54g of the developing tank 54, and the washing solution Q is pressed out to a first tank portion M₁ side where the flexographic printing plate precursor 36 enters. Consequently, for example, the washing solution Q overflows and moves from the developing tank 54 to the tank 69 (see Fig. 14). In this case, in a case where the washing solution Q contains solid contents, the solid contents are captured by the filter 29, and the washing solution Q from which the solid contents are removed is transferred to the circulation pump 68 as a regenerated washing solution.

In addition, the washing solution Q overflowing the developing tank 54 or a fatiqued developer Qw, which is the developed washing solution Q, is transferred to the waste liquid tank 65 through the connecting pipe 65a.

The restricting member 71 is a member that restricts a flow passage for the washing solution Q flowing in the intersecting direction to cross the width of the flexographic printing plate precursor 36 in at least one of the first region Di or the second region D₂. The restricting member 71 forms an elongated flow passage through which the washing solution Q in the first region Di and the second region D₂ flows. In the flow passage, a range where the washing solution Q flows is made narrower than in a case where the restricting member 71 is not provided. Accordingly, in a case of flowing the washing solution Q, diffusion of the washing solution Q is suppressed, and a decrease in the flow rate of the washing solution Q is suppressed.

In addition, as shown in Figs. 15 and 16, by providing the restricting member 71, a decrease in the flow rate of the washing solution Q can be suppressed without making the volume of the developing tank 54 small.

In a case where the developing tank 54 is viewed from the liquid level Qs, the restricting member 71 is a quadrangular member and is disposed with a gap with respect to the brush 61. The gap is a flow passage for the washing solution Q.

The restricting member 71 may be provided in at least one of the first region Di or the second region D₂. However, it is preferable that the restricting member 71 is provided in the second region D₂ where the flexographic printing plate precursor 36 is discharged, among the first region Di and the second region D₂.

The restricting member 71 is not particularly limited insofar the flow passage for the washing solution Q can be restricted and is, for example, a rectangular parallelepiped member. A material for the restricting member 71 is not particularly limited, and examples thereof include a vinyl chloride resin block, a polyethylene resin block, a polypropylene resin block, a foamed molded body, or the like. In addition, as a range for providing the restricting member 71, it is preferable that the restricting member is disposed such that a straight line is formed from a supply port 16 toward the overflow port 69b as shown in Fig. 16. In a case where there is an uneven portion in a liquid interface portion of the restricting member 71, the flow is hindered. In addition, since the restricting member 71 prevents a flow in a liquid interface other than a portion between the overflow ports 69b from the supply port 16 and floating substances are likely to stay, a size that covers the liquid interface which does not form a flow passage is preferable.

### <Washing Method>

Since a washing method of the washout processor 10c is the same method for the washout processor 10b described above although the partition member 70 and the restricting member 71 are provided, detailed description thereof will be omitted.

Since the washout processor 10c is provided with the partition member 70 and the restricting member 71, a decrease in the flow rate of the washing solution Q can be suppressed, and solid contents are more unlikely to be attached to the front surface 36a of the developed flexographic printing plate precursor 36.

### (Another Example of Rinsing Unit)

The configuration of the rinsing unit 52 is not limited to the configuration shown in Figs. 6 and 15, and for example, the rinsing unit 52 having a configuration to be described below can be used.

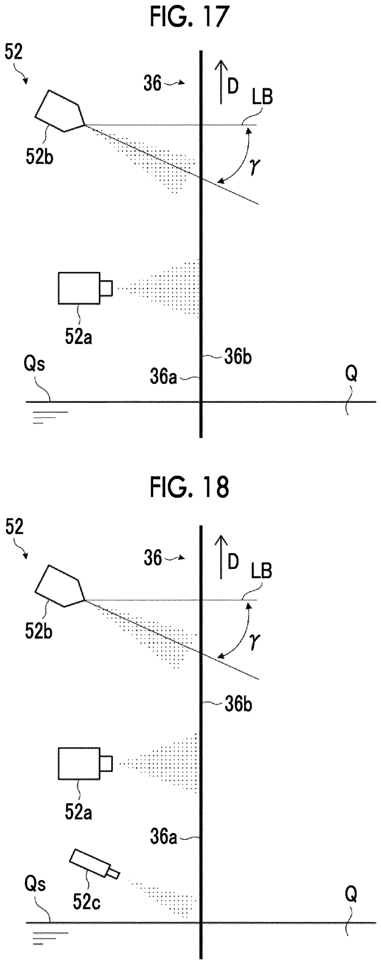

Fig. 17 is a schematic view showing a first example of the rinsing unit of the third example of the washout processor according to the embodiment of the present invention. Fig. 18 is a schematic view showing a second example of the rinsing unit of the third example of the washout processor according to the embodiment of the present invention. In Figs. 17 and 18, the same components as those of the washout processor 10b shown in Fig. 6 will be assigned with the same reference numerals, and detailed description thereof will be omitted. In Figs. 17 and 18, showing of configurations other than the configuration of the rinsing unit 52 will be omitted.

For example, as shown in Fig. 17, above the liquid level Qs of the washing solution Q, the rinsing unit 52 has the rinsing liquid supply unit 52a disposed to face the front surface 36a of the flexographic printing plate precursor 36 and the liquid drain nozzle 52b provided on the downstream side of the rinsing liquid supply unit 52a in the traveling direction of the flexographic printing plate precursor 36, that is, the downstream side in the transport direction D.

As shown in Fig. 17, as the rinsing liquid supply unit 52a and the liquid drain nozzle 52b are provided, the liquid drain nozzle 52b entrains the washing solution Q from the rinsing liquid supply unit 52a, the washing solution Q spreads on the front surface 36a of the flexographic printing plate precursor 36 even in a case where a supply amount of the washing solution from the rinsing liquid supply unit 52a is small, and thereby the non-exposed portion described above can be removed. Accordingly, the amount of the washing solution Q necessary for removing residues such as latex components and rubber components remaining on the front surface 36a of the developed flexographic printing plate precursor 36 can be decreased.

It is preferable to drive the rinsing liquid supply unit 52a and the liquid drain nozzle 52b simultaneously. By driving the rinsing liquid supply unit 52a and the liquid drain nozzle 52b simultaneously, the effect of entrainment of the washing solution Q described above is further obtained.

A nozzle angle γ of the liquid drain nozzle 52b is preferably 0° to 45°.

In a case where a ventilation port for a gas of the liquid drain nozzle 52b is on a line LB of 90° (hereinafter, referred to as a reference line LB) with respect to the front surface 36a of the flexographic printing plate precursor 36, the nozzle angle γ is set to 0°.

An angle formed by a line that is extended from the front surface 36a of the flexographic printing plate precursor 36 and that passes through the ventilation port of the liquid drain nozzle 52b and the reference line LB is the nozzle angle γ.

In addition, as shown in Fig. 18, a configuration where a prerinsing nozzle 52c is provided to face the front surface 36a of the flexographic printing plate precursor 36 may be adopted in addition to the configuration shown in Fig. 17.

The prerinsing nozzle 52c sprays the washing solution Q in order to prevent foreign substances from being attached to the flexographic printing plate precursor 36 at the surface of the washing solution Q in the developing tank 54. It is preferable that the washing solution Q is supplied from the prerinsing nozzle 52c at a flow rate that disturbs the liquid level Qs of the washing solution Q in the developing tank 54.

In the developing tank 54, residues generated by development float on the liquid level Qs of the washing solution Q in the developing tank 54. In a case where the residues are attached to the front surface 36a and the back surface 36b of the flexographic printing plate precursor 36, a defect is caused. There are also residues which are too small to be removed by the rinsing liquid supply unit 52a, and a defect is caused in a case where the residues are attached. By providing the prerinsing nozzle 52c, the small residues are prevented from being attached, and the cleanliness of the front surface 36a of the flexographic printing plate precursor 36 can be increased.

### (Example of Heater)

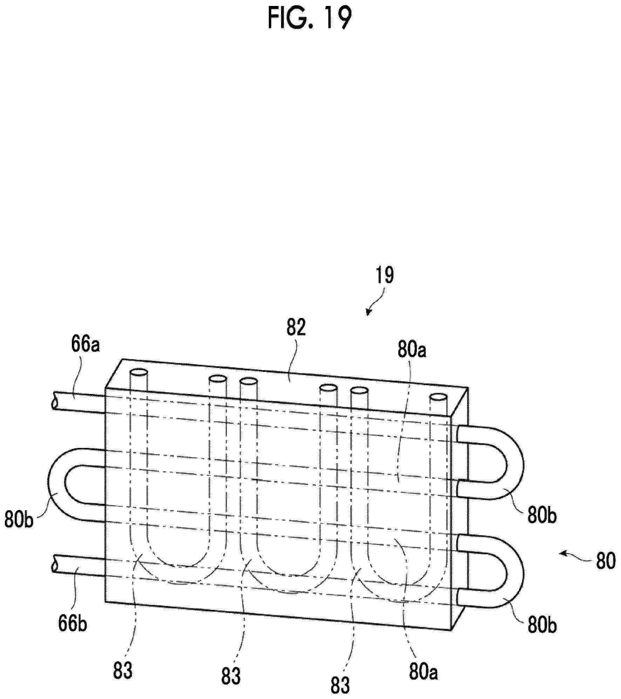

Fig. 19 is a schematic perspective view showing an example of the heater used in the washout processor according to the embodiment of the present invention. In Fig. 19, the same components as those of the washout processor 10b shown in Fig. 6 will be assigned with the same reference numerals, and detailed description thereof will be omitted.

As shown in Fig. 6, the heater 19 is connected to the filter 18 and the developing tank 54. As described above, the temperature of the washing solution Q is adjusted, and the heater 19 is used to adjust the temperature of the washing solution Q.

As shown in Fig. 19, the heater 19 has a pipe 80, a block 82 in which a part of the pipe 80 is buried, and a heating heater 83 provided in the block 82. The block 82 is formed of a metal material. The metal material forming the block 82 is preferably a metal material excellent in castability and is, for example, copper, a copper alloy, aluminum, or an aluminum alloy.

As the pipe 80, one pipe is seamlessly disposed in the block 82. The pipe has a linear part 80a inside the block 82 and a bending part 80b connecting the linear part 80a inside. The bending part 80b is disposed outside the block 82. In addition, for example, three heating heaters 83 are disposed at intervals in a direction in which the linear part 80a of the pipe 80 extends.

The linear part 80a of the pipe 80 and the heating heater 83 are cast and integrated with the block 82.

A device used as a cast heater is usable as appropriate as the heating heater 83.

An overheat protection device such as a thermostat (not shown) is provided inside the heater 19 and cuts off power in a case where abnormal overheating occurs. In this manner, a treatment liquid including the washing solution can be maintained at a predetermined temperature.

It is preferable that the watt density of the heating heater 83 of the heater 19 is 5 W/cm² or less. In a case where the watt density of the heating heater 83 is set to 5 W/cm² or less, a heat generation temperature of a heat generating body can be relatively kept low, and the life of the heat generating body can be extended. Since it is difficult to repair the heating heater 83 in a case where the heating heater 83 is cast, the occurrence of a failure of the heater 19 can be suppressed.

Having a low watt density extends the life of the heater, but the heater block becomes large and costs increase in a case where the watt density is 1 W/cm² or less, which is not practical. The watt density of the heating heater 83 is more preferably 3 to 5 W/cm².

As the heater 19 has the configuration described above, the washing solution Q does not come into direct contact with the heating heater 83, and heat is uniformly exchanged in the linear part 80a. Thus, local burning is suppressed even in the washing solution Q containing solid contents.

As the washing solution Q passes through the inside of the pipe in the block at a liquid flow rate of 100 cm/sec or more, burning of the washing solution Q containing the solid contents is suppressed even in a case where a heating setting temperature of the heater 19 is approximately 100°C and the concentration of the solid contents of the washing solution Q is high. For this reason, the flow rate of the washing solution in the heater 19 is preferably 100 cm/sec and more preferably 200 cm/sec or more. For example, the heater 19 has a pump that causes the washing solution Q to pass through the inside of the pipe in the block at a liquid flow rate of 100 cm/sec or more. The pump is, for example, the circulation pump 17.

The flow rate of the washing solution in the heater 19 can be measured by various types of commercially available liquid flow meters. In addition, the flow rate of the washing solution in the heater 19 can also be acquired by calculating from a cross-sectional area in the pipe of the heater 19 and a circulation amount of the pump.

The heater 19 shown in Fig. 6 is also called a cast heater. In addition to the description above, a cast heater can be used as the heater. In addition to the cast heater, for example, a metal block heater in which a heater and a pipe through which a liquid is passed are press-fitted into a metal block, a heater in which a cartridge heater or a sheathed heater and a metal pipe are set in a mold and a metal is injected, or the like can be used.

The heater 19 shown in Fig. 19 is not limited to being used in the washout processor 10b shown in Fig. 6 and can also be used in the washout processor 10, the washout processor 10a, and the washout processor 10c which are described above.

### (Transporting Unit)

Although the transporting unit 50 of the washout processors 10b and 10c described above, which adopts a winding transmission method in which the gear 55 and the transport chain 56 are used, is described as an example, the transporting unit 50 is not limited thereto. For example, the gear 55 may be changed to a pulley, and the transport chain 56 may be changed to a transport belt. The flexographic printing plate precursor is transported by using a pair of transport belts and fixing each transport belt to the leaders.

In a case of using the transport belts, the transport belts hang parallel to each other. The transport belts are also not particularly limited, and flat belts, V-belts, rib belts, round belts, and toothed belts can be used.

In addition to the above, the transporting unit 50 can use, for example, a winding method of winding a traction member provided at the leader.

In a case of the winding method described above, for example, the traction member (not shown) for transporting the flexographic printing plate precursor 36 is attached to the leader for the flexographic printing plate precursor 36, and the flexographic printing plate precursor 36 is transported along the transport path Dp described above by winding the traction member. The traction member may be a string or may be a strip-shaped member.

### (Flexographic Printing Plate Precursor)

The flexographic printing plate precursor 36 forms a flexographic printing plate used in flexographic printing, and the configuration thereof is not particularly limited. The flexographic printing plate precursor 36 is as thin as several millimeters and has flexibility. Having flexibility means returning from a bent state caused by an acting force to the original state after unloading the force. The size of the flexographic printing plate precursor 36 is, for example, 800 mm × 1,200 mm, and 1,050 mm × 1,500 mm. Since development is performed by moving the brush 41, it is also possible to respond to the large flexographic printing plate precursor 36.

It is preferable that the flexographic printing plate precursor 36 is a flexographic printing plate precursor that can be developed with an aqueous developer of which a main component is water and a flexographic printing plate precursor that is called a water-developing type flexographic printing plate precursor. In this case, the washing solution is the aqueous developer.

A known flexographic printing plate precursor that can be developed with the aqueous developer is usable as the flexographic printing plate precursor 36, and a flexographic plate material for computer to plate (CTP) having a surface to which a black layer is applied may be used as the flexographic printing plate precursor 36.

Hereinafter, the washing solution will be described.

### <Washing Solution>

The washing solution is preferably a water-based washing solution, may be a solution consisting of only water, and may be an aqueous solution which contains 50% by mass or more of water and to which a water soluble compound is added. Examples of the water soluble compound include surfactants, acids, and alkalis. The water-based washing solution described above corresponds to the aqueous developer.

Examples of the surfactant include anionic surfactants, nonionic surfactants, cationic surfactants, and amphoteric surfactants, and among the surfactants, anionic surfactants are preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfates such as sodium polyoxyethylene lauryl ether sulfate; polyoxyethylene alkyl allyl ether sulfates such as sodium polyoxyethylene octylphenyl ether sulfate and sodium polyoxyethylene nonylphenyl ether sulfate; alkyl sulfonates such as alkyldiphenyl ether disulfonate, sodium dodecyl sulfonate, and sodium dialkyl sulfosuccinate; alkyl allyl sulfonates such as alkyl disulfonate, sodium dodecylbenzene sulfonate, sodium dibutylnaphthalene sulfonate, and sodium triisopropylnaphthalene sulfonate; higher alcohol phosphate ester salts such as lauryl phosphate monoester disodium and sodium lauryl phosphate diester; polyoxyethylene alkyl ether phosphoric acid ester salts such as polyoxyethylene lauryl ether phosphoric acid monoester disodium and polyoxyethylene lauryl ether phosphoric acid diester sodium. These may be used alone or may be used in combination of two or more types. Although a sodium salt is given as a specific example, it is not particularly limited to the sodium salt, and the same effect can be obtained with a calcium salt, an ammonia salt, or the like.

Specific examples of the nonionic surfactant include polyoxyethylene alkyl ethers such as polyoxyethylene oleyl ether and polyoxyethylene lauryl ether, polyoxyethylene polyoxypropylene glycols including polyoxyethylene alkyl phenyl ethers such as polyoxyethylene nonylphenyl ether and polyoxyethylene octylphenyl ether, mono and diesters of polyethylene glycol and fatty acids such as polyethylene glycol monostearate, polyethylene glycol monooleate, and polyethylene glycol dilaurate, fatty acids and sorbitan esters such as sorbitan monolaurate and sorbitan monooleate, esters of sorbitan polyoxyethylene adducts and fatty acids such as polyoxyethylene sorbitan monolaurate, polyoxyethylene sorbitan monostearate, and polyoxyethylene sorbitan trilaurate, esters fatty acids and sorbitol such as sorbitol monopalmitate and sorbitol dilaurate, esters of sorbitol polyoxyethylene adducts and fatty acids such as polyoxyethylene sorbitol monostearate and polyoxyethylene sorbitol diolate, esters of fatty acids and pentaerythritol such as pentaerythritol monostearate, esters of fatty acids and glycerin such as glycerin monolaurate, fatty acid alkanolamides such as lauric acid diethanolamide and lauric acid monoethanolamide, amine oxides such as lauryl dimethylamine oxide, fatty acid alkanolamines such as stearyl diethanolamine, polyoxyethylene alkylamines, triethanolamine fatty acid esters, alkaline salt compounds such as phosphates, carbonates, and silicates. These may be used alone or may be used in combination of two or more types.

Specific examples of the cationic surfactant include primary, secondary and tertiary amine salts such as monostearylammonium chloride, distearylammonium chloride, and tristearylammonium chloride, quaternary ammonium salts such as stearyltrimethylammoum chloride, distearyldimethylammonium chloride, and stearyldimethylbenzylammonium chloride, alkylpyridinium salts such as N-cetylpyridinium chloride and N-stearylpyridinium chloride, N, N dialkyl morpholinium salts, fatty acid amide salts of polyethylene polyamines, acetic acids of urea compounds of amides of aminoethylethanolamine and stearic acid, and 2-alkyl-1-hydroxyethylimidazolinium chloride. These may be used alone or may be used in combination of two or more types.

Specific examples of the amphoteric surfactant include amino acid types such as sodium laurylamine propionate, carboxybetaine types such as lauryldimethylbetaine and lauryldihydroxyethylbetaine, sulfobetaine types such as stearyldimethylsulfoethyleneammonium betaine, imidazolenium betaine types, and lecithin. These may be used alone or may be used in combination of two or more types.

Specific examples of the acid include inorganic acids or organic acids such as hydrochloric acid, sulfuric acid, nitric acid, phosphoric acid, formic acid, acetic acid, oxalic acid, succinic acid, citric acid, malic acid, maleic acid, and paratoluenesulfonic acid.

Specific examples of the alkali include lithium hydroxide, sodium hydroxide, magnesium hydroxide, potassium hydroxide, calcium hydroxide, calcium oxide, sodium carbonate, sodium hydrogencarbonate, and calcium carbonate.

Hereinafter, the fatiqued developer will be described in detail.

### <Fatiqued Developer>

The fatiqued developer is not particularly limited insofar as the fatiqued developer is a washing solution containing solid contents generated by removing the non-exposed portion of the flexographic printing plate precursor due to development using the washing solution described above, that is, a washing solution containing an uncured resin. However, a fatiqued developer containing a known photosensitive resin composition of the related art for forming a general photosensitive resin layer may be included.

The uncured resin removed through development may be a photosensitive resin contained in the photosensitive resin composition.

In addition, since it is preferable to set a fatiqued developer in a case of developing under a laser ablation masking (LAM) method as a processing target, it is preferable that the uncured resin removed through development is the photosensitive resin contained in the photosensitive resin composition.

In addition, since examples of such a photosensitive resin composition include a composition containing a polymerization initiator, a polymerizable compound, a polymerization inhibitor, and a plasticizer, in addition to the photosensitive resin, the fatiqued developer may contain a polymerization initiator, a polymerizable compound, a polymerization inhibitor, a plasticizer, and the like, in addition to the uncured resin.

### <Uncured Resin>

The uncured resin contained in the fatiqued developer is solid substances generated by removing the non-exposed portion and is also referred to as solid contents. Examples of the uncured resin contained in the fatiqued developer include water-dispersible latex, rubber components, polymer components, and uncrosslinked ethylenically unsaturated compounds (polymers).

Examples of the water-dispersible latex include water-dispersed latex polymers including water-dispersed latex such as polybutadiene latex, natural rubber latex, styrenebutadiene copolymer latex, acrylonitrile-butadiene copolymer latex, polychloroprene latex, polyisoprene latex, polyurethane latex, methyl methacrylate-butadiene copolymer latex, vinyl pyridine copolymer latex, butyl polymer latex, thiocol polymer latex, and acrylate polymer latex and polymers obtained by copolymerizing these polymers with other components such as acrylic acid or methacrylic acid.

Examples of the rubber component include butadiene rubber, isoprene rubber, styrenebutadiene rubber, acrylonitrile rubber, acrylonitrile butadiene rubber, chloroprene rubber, polyurethane rubber, silicon rubber, butyl rubber, ethylene-propylene rubber, and epichlorohydrin rubber.

The polymer component may be hydrophilic or may be hydrophobic, and specific examples thereof include a polyamide resin, an unsaturated polyester resin, an acrylic resin, a polyurethane resin, a polyester resin, and polyvinyl alcohol resin.

The solid substances (solid contents) having a specific gravity lower than the washing solution are, for example, photosensitive resins such as rubber components and latex.

The solid substances (solid contents) having a specific gravity higher than the washing solution are, for example, components of overcoat layers such as carbon.

Examples of the ethylenically unsaturated compound (polymer) include (meth) acrylic modified polymers having an ethylenically unsaturated bond in the molecule.

Examples of the (meth) acrylic modified polymer include (meth) acrylic modified butadiene rubber and (meth) acrylic modified nitrile rubber.

"(Meth) acrylic" is a notation representing acrylic or methacrylic, and "(meth) acrylate" to be described later is a notation representing acrylate or methacrylate.

The uncured resin contained in the fatiqued developer is not particularly limited, but is preferably 70% by mass or less, and more preferably 35% by mass or less.

### <Polymerization Initiator>

The polymerization initiator that may be contained in the fatiqued developer is preferably a photopolymerization initiator.

Examples of the photopolymerization initiator described above include alkylphenones, acetophenones, benzoin ethers, benzophenones, thioxanthones, anthraquinones, benzyls, and biacetyls, and among them, alkylphenones are preferable.

Specific examples of the alkylphenones photopolymerization initiators include 2,2-dimethoxy-1,2-diphenylethane-1-one, 1-hydroxy-cyclohexyl-phenyl-ketone, and 2-hydroxy-2-methyl-1-phenyl-propane-1-one.

The concentration of the polymerization initiator that may be contained in the fatiqued developer is not particularly limited, but is preferably 2.0% by mass or less, and more preferably 1.0% by mass or less.

### <Polymerizable Compound>

Examples of the polymerizable compound that may be contained in the fatiqued developer include ethylenically unsaturated compounds that correspond to so-called monomer components other than the ethylenically unsaturated compounds (polymers) described above.

The ethylenically unsaturated compound may be a compound having one ethylenically unsaturated bond or may be a compound having two or more ethylenically unsaturated bonds.

Specific examples of the compound having one ethylenically unsaturated bond include (meth) acrylate having a hydroxyl group such as 2-hydroxyethyl (meth) acrylate, 2-hydroxypropyl (meth) acrylate, 2-hydroxybutyl (meth) acrylate, 3-chloro-2-hydroxypropyl (meth) acrylate, and β-hydroxy-β'-(meth) acryloyloxyethyl phthalate; alkyl (meth) acrylates such as methyl (meth) acrylate, ethyl (meth) acrylate, propyl (meth) acrylate, butyl (meth) acrylate, isoamyl (meth) acrylate, 2-ethylhexyl (meth) acrylate, lauryl (meth) acrylate, and stearyl (meth) acrylate; cycloalkyl (meth) acrylates such as cyclohexyl (meth) acrylate; alkyl halogenated (meth) acrylates such as chloroethyl (meth) acrylate and chloropropyl (meth) acrylate; alkoxyalkyl (meth) acrylates such as methoxyethyl (meth) acrylate, ethoxyethyl (meth) acrylate, and butoxyethyl (meth) acrylate; phenoxyalkyl (meth) acrylates such as phenoxyethyl acrylate and nonylphenoxyethyl (meth) acrylate; alkoxyalkylene glycol (meth) acrylates such as ethoxydiethylene glycol (meth) acrylate, methoxytriethylene glycol (meth) acrylate, and methoxydipropylene glycol (meth) acrylate; 2,2-dimethylaminoethyl (meth) acrylate, 2,2-diethylaminoethyl (meth) acrylate, 2-hydroxyethyl (meth) acrylate, and 3-chloro-2-hydroxypropyl (meth) acrylate.

Specific examples of the ethylenically unsaturated compound having two or more ethylenically unsaturated bonds include alkyldiol di (meth) acrylates such as 1,9-nonane diol di (meth) acrylate; polyethylene glycol di (meth) acrylates such as diethylene glycol di (meth) acrylate; polypropylene glycol di (meth) acrylates such as dipropylene glycol di (meth) acrylate; polyvalent (meth) acrylates obtained by addition reaction of a compound having an ethylenically unsaturated bond, such as unsaturated carboxylic acid and unsaturated alcohol, and active hydrogen with trimethylolpropane tri (meth) acrylate, pentaerythritol tri (meth) acrylate, pentaerythritol tetra (meth) acrylate, glycerol tri (meth) acrylate, and ethylene glycol diglycidyl ether; polyvalent (meth) acrylates obtained by addition reaction of an unsaturated epoxy compound such as glycidyl (meth) acrylate with a compound having active hydrogen such as carboxylic acid and amine; polyvalent (meth) acrylamides such as methylenebis (meth) acrylamide; polyvalent vinyl compounds such as divinylbenzene.

The concentration of the polymerizable compound that may be contained in the fatiqued developer is not particularly limited, but is preferably 30.0% by mass or less, and more preferably 15.0% by mass or less.

### <Polymerization Inhibitor>

Specific examples of the polymerization inhibitor that may be contained in the fatiqued developer include hydroquinone monomethyl ether, p-methoxyphenol, di-t-butyl-p-cresol, pyrogallol, t-butylcatechol, benzoquinone, 4,4'-thiobis (3-methyl-6-t-butylphenol), 2,2'-methylenebis (4-methyl-6-t-butylphenol), and N-nitrosophenylhydroxyamine cerous salt.

The concentration of the polymerization inhibitor that may be contained in the fatiqued developer is not particularly limited, but is preferably 0.3% by mass or less, and more preferably 0.15% by mass or less.

### <Plasticizer>

Examples of the plasticizer that may be contained in the fatiqued developer include liquid rubber, oil, polyester, and phosphoric acid-based compounds.

Specific examples of the liquid rubber include liquid polybutadiene, liquid polyisoprene, and those modified with maleic acid or an epoxy group.

Specific examples of the oil include paraffin oil, naphthenic oil, and aroma oil.

Specific examples of the polyester include adipic acid-based polyester.

Specific examples of the phosphoric acid-based compound include phosphoric acid ester.

The concentration of the plasticizer that may be contained in the fatiqued developer is not particularly limited, but is preferably 30% by mass or less, and more preferably 15% by mass or less.

The present invention is basically configured as described above. Although the washout processor and the washing method according to the embodiment of the present invention have been described in detail hereinbefore, the present invention is not limited to the embodiment described above, and it is evident that various improvements or changes may be made without departing from the gist of the present invention.

### [Example 1]

Hereinafter, the present invention will be described in further detail with reference to examples. Materials, reagents, amounts used, substance amounts, ratios, the content of processing, processing procedures, and the like shown in the examples below can be changed as appropriate without departing from the scope of the present invention. Therefore, the scope of the present invention is not to be construed as being limited by specific examples described below.

Devices and chemicals to be used are as follows.
<Imaging Machine>
   · CDI Spark 4835 Inline (manufactured by Esko-Graphics Co.,Ltd.)
<Exposure Machine>
   · Ultraviolet rays exposure machine Concept 302 ECDLF (product name) (manufactured by Glunz & Jensen)
<Flexographic Printing Plate Precursor>
   · FLENEX FW-L (manufactured by Fujifilm Global Graphic Systems Co., Ltd.)
   · Plate size 1,542 mm × 1,067 mm
<Washing Solution>
   · Aqueous solution (concentration is 0.5% by mass) of Finish Power & Pure Powder SP (manufactured by Reckitt Benckiser Japan Ltd.)
   · Liquid temperature 50°C
<Imagewise Exposure of Flexographic Printing Plate Precursor>

Back exposure was performed by exposing the flexographic printing plate precursor described above from the back surface of the flexographic printing plate precursor with energy of 80 W for 10 seconds using the ultraviolet rays exposure machine described above. After then, main exposure was performed by imaging a mask layer by ablation using the imaging machine described above and exposing from a front surface (a back surface of the back surface) with 80 W for 1,000 seconds. The flexographic printing plate precursor on which main exposure was performed was used as the imagewise exposed flexographic printing plate precursor.

### (Post-exposure Step)

After development treatment, drying was performed with hot air of 60°C until moisture was removed.

After the drying was performed, without disposing the mask layer, exposure (post-exposure) was performed with an exposure amount of 2,000 mJ/cm² from a position separated by a distance of 15 cm from a photosensitive layer side, using the exposure device described above. Accordingly, a flexographic printing plate was obtained.

Hereinafter, the concentration of solid contents and on-plate residues will be described.

### [Concentration of Solid Contents]

The washing solution was subjected to quantitative sampling, was dried and solidified in an oven at a temperature of 95°C for 24 hours, was taken out from the oven, was cooled at room temperature for 5 minutes, and then was measured by mass, and the concentration of solid contents was calculated from the mass before and after drying.

### [On-plate Residues]

After development treatment of the flexographic printing plate precursor, drying and post-exposure described above were performed.

Next, removal was performed on the flexographic printing plate precursor using tape, and all those which could not be removed were defined as on-plate residues.

The presence or absence of on-plate residues that had a size of 100 µm or more and could not be removed using tape was checked, and the number of on-plate residues per 1 m² was evaluated.

Next, examples 1 and 2 and comparative example 1 will be described.

### (Example 1)

In example 1, in the washout processor 10b shown in Fig. 6, the temperature of 600 L of the washing solution was adjusted to a temperature of 50°C, and the washing solution was supplied to the developing tank. The washing solution was flowed to a discharge side of the imagewise exposed flexographic printing plate precursor described above in a direction intersecting the traveling direction of the flexographic printing plate precursor. The brush 61 was transported at a transportion speed of 4 mm/sec and was rotated at 30 rpm, and the brush 61 was swung at 24 mm/sec in the width direction to perform development treatment. After development, the rinsing unit supplied water, which was a rinsing liquid, to a development surface of the flexographic printing plate precursor such that a total amount of a treatment agent replenishment liquid excluding evaporation correction water and the rinsing liquid was 7.0 L/m² per plate area. That is, approximately 11.5 L of water per one flexographic printing plate precursor was supplied as the rinsing liquid. An amount to be supplied as the rinsing liquid was the amount of water obtained by adding the evaporated amount.

Further, air was jetted at 800 L/min to the flexographic printing plate precursor from an air blow nozzle at a jetting pressure of 0.07 MPa to remove water droplets attached to the flexographic printing plate precursor.

As a washing solution, a detergent and a rinsing liquid were supplied using the replenishment pump such that the concentration of the detergent of the developing tank can be maintained at 0.5% using the dishwasher detergent finish. In a case where treatment was continued such that the total amount of the treatment agent replenishment liquid excluding the evaporation correction water and the rinsing liquid was 7.0 L/m² per plate area, the concentration of solid contents in the developing tank including solid contents of the detergent gradually increased, and the concentration of solid contents after treatment of approximately 300 m² reached equilibrium of 6.3%. In this case, it was checked that a large amount of floating substances were aggregated on the liquid level of the developing tank.

In example 1, even in a case where floating substances on the liquid level of the washing solution were swept away and the concentration of solid contents in the washing solution was 6.3%, the solid contents were not attached to the flexographic printing plate precursor. That is, the number of on-plate residues was zero.

### (Example 2)

Example 2 was the same as example 1, except that the filter 29 was used in a case of circulating the washing solution, compared to example 1.

In example 2, as in example 1, solid contents were not attached to the flexographic printing plate precursor. That is, the number of on-plate residues was zero.

In addition, the concentration of solid contents in the washing solution was decreased from 6.3% to 4.8%. By providing the filter, a load on the filter 18 (see Fig. 6) provided at a discharge destination of the circulation pump 17 (see Fig. 6) could be reduced, and an effect of lowering the concentration of solid contents dispersed in the washing solution was recognized.

### [Example 2]

### (Example 10)

Example 10 was different from example 1 in that rinsing treatment was not performed and the liquid flow rate of the washing solution was different, but other points were the same as in example 1.

In example 10, the washing solution was flowed at a liquid flow rate of 70 cm/sec to the discharge side of the imagewise exposed flexographic printing plate precursor described above in the direction intersecting the traveling direction of the flexographic printing plate precursor using the circulation pump 17 (see Fig. 6). The liquid flow rate of the washing solution was 33 cm/sec immediately before the overflow port that was on the opposite side of a place where the washing solution flows 2,250 mm in terms of the width of the developing tank.

The liquid flow rate of the washing solution was measured using SI5007 manufactured by ifm efector Co., Ltd.

### (Example 11)

Example 11 was different from example 10 in terms of the liquid flow rate of the washing solution, but other points were the same as in example 10.

In example 11, the liquid flow rate of the washing solution at the supply port was 110 cm/sec, and the liquid flow rate of the washing solution at the overflow port was 42 cm/sec. (Example 12)

Example 12 was different from example 10 in terms of the liquid flow rate of the washing solution, but other points were the same as in example 10.

In example 12, the liquid flow rate of the washing solution at the supply port was 130 cm/sec, and the liquid flow rate of the washing solution at the overflow port was 48 cm/sec. (Example 13)

Example 13 was different from example 10 in terms of the liquid flow rate of the washing solution, but other points were the same as in example 10.

In example 13, the liquid flow rate of the washing solution at the supply port was 150 cm/sec, and the liquid flow rate of the washing solution at the overflow port was 55 cm/sec.

**[Table 1]**

| | Liquid flow rate of washing solution (cm/sec) | | On-plate residues (piece/m²) |
|---|---|---|---|
| | Supply port | Overflow port | |
| Example 10 | 70 | 33 | 6 |
| Example 11 | 110 | 42 | 2 |
| Example 12 | 130 | 48 | 1 |
| Example 13 | 150 | 55 | 0 |

The flexographic printing plate precursor had a width of 1,067 mm, a feed length of 1,542 mm, and an area of 1.645 m². Water was sprayed as a rinsing liquid to the flexographic printing plate precursor such that the amount thereof was 7.0 L/m², that is, approximately 11.5 L per one flexographic printing plate precursor. In a case where a spray amount of the rinsing liquid was large, the amount of a waste liquid increased, so that it was preferable to wash away the detergent with an extremely small amount of the rinsing liquid and to wash off a remaining attachment.

Even without washing away using the rinsing liquid, in a case where the liquid flow rate was 50 cm/sec or more at the overflow port which was a reaching point of the washing solution, residues such as floating solid contents could be prevented from being attached to the flexographic printing plate precursor.

In a case of flowing the washing solution in the direction intersecting the traveling direction of the flexographic printing plate precursor, the washing solution decelerated until reaching the overflow port from the supply port. For this reason, the flow rate at the supply port was set such that the flow rate at the overflow port, which was the reaching point, could be ensured. In addition, in a case where the area of a flow passage through which the washing solution flows was large, the flow was diffused and easily decelerated. For this reason, by providing the restricting member in a portion where the flexographic printing plate precursor enters or was carried out of the washing solution in order to narrow the flow passage for the washing solution, the liquid flow rate of the washing solution could be further ensured such that a circulation flow rate of the washing solution was low, which was more preferable.

As a comparative example, in a case of not flowing the washing solution in the direction intersecting the traveling direction of the flexographic printing plate precursor, it was known that a state where an attachment to the flexographic printing plate precursor was removed at 20 L/m² or more after the amount of a rinsing liquid gradually increased from 7.0 L/m². Thus, it was known that in examples 10 to 13, there was an effect of reducing a waste liquid amount of 20 L per glass of a polytank in the plate treatment of 1 m².

In the method of the related art, in which the concentration of a detergent was maintained at 0.5% (concentration of solid contents) and addition of 20 L/m² of a rinsing liquid was performed to continue the treatment, in a case where the volume of the washing solution was 600 Land 100 m² of the flexographic printing plate precursor was treated, the concentration of solid contents of the washing solution in the developing tank transitioned at approximately 2.6%. On the contrary, since rinsing treatment was not performed as described above in examples 10 to 13, a rinsing liquid amount causing an increase in the waste liquid amount could be reduced.

### [Example 3]

In the washout processor 10b shown in Fig. 6, the temperature of 600 L of the washing solution was adjusted to a temperature of 50°C, and the washing solution was supplied to the developing tank. The washing solution was flowed to the discharge side of the imagewise exposed flexographic printing plate precursor described above in the direction intersecting the traveling direction of the flexographic printing plate precursor. The brush 61 was transported at a transportion speed of 4 mm/sec and was rotated at 30 rpm, and the brush 61 was swung at 24 mm/sec in the width direction to perform development treatment. The temperature adjustment of the washing solution was evaluated using various types of heaters.

A heater 1 was an immersion heater. As the immersion heater, a sheathed heater manufactured by Kawai Corporation was used. The immersion heater (200 V, 3 P, 8 kW, power density of 6.1 W/cm²), in which three sheathed heaters that had a diameter of 12 mm and that were U-shaped with a length of 600 mm were used as one set, was used.

A heater 2 was a circulation pipe type heater. As the circulation pipe type heater, a pipe heater, in which a stainless steel pipe 65A (diameter 76.3 × thickness 2.1) was used, a cartridge heater having a diameter of 41.3 mm and a length of 800 mm (200 V, 3 P, 6 kW, power density of 5.0 W/cm²) was inserted into a central portion of the pipe, and a liquid flowed around the cartridge heater in the stainless steel pipe, was used.

A heater 3 was a cast heater. As the cast heater, four stainless steel pipes 20A (diameter 27.2 × thickness 1.65) were used, and each pipe portion of 600 mm was manufactured by casting with aluminum by a sheathed heater (200 V, 3 P, 8 kW, power density of 4.7 W/cm²).

Using the heaters 1 to 3, the burning of the washing solution was evaluated by changing the concentration of solid contents of the washing solution. In table 2 below, those with burning were indicated as "Present", and those without burning were indicated as "Absent". A liquid was subjected to quantitative sampling, was dried and solidified in an oven at 95°C for 24 hours, was taken out from the oven, was cooled at room temperature for 5 minutes, and then was measured by weight, and the concentration of solid contents of a treatment liquid was calculated from the weight before and after drying. The washing solution was subjected to quantitative sampling, was dried and solidified in the oven at 95°C for 24 hours, was taken out from the oven, was cooled at room temperature for 5 minutes, then the mass was measured, and the concentration of solid contents of the washing solution was calculated from the mass before and after drying.

**[Table 2]**

| Heater type | Concentration of solid contents of washing solution | | | | | Cross-sectional area (m²) | Liquid flow rate (cm/sec) |
|---|---|---|---|---|---|---|---|
| | 1% | 3% | 5% | 8% | 12% | | |
| Heater 1 | Absent | Present | Present | Present | Present | - | 10 |
| Heater 2 | Absent | Absent | Present | Present | Present | 27.4 | 36 |
| Heater 3 | Absent | Absent | Absent | Absent | Absent | 4.5 | 220 |

In the heater 3 (cast heater), it was checked that treatment could be continued without burning solid contents with the heater even under operating conditions that the concentration of the solid contents rose to 12%. In the heater 3, since development treatment could be continued even in a case where the concentration of the solid contents was 12%, in a case where the supply amount was decreased to 3.3 L/m² and the same treatment was continued from a condition in which a rinsing liquid water amount was supplied by the replenishment pump with 7.0 L/m² of a detergent and the rinsing liquid such that the concentration of the detergent of the developing tank could be maintained at 0.5% using the dishwasher detergent finish of example 1, the concentration of solid contents in a treatment tank including the solid contents of the detergent was gradually increased, and the concentration of solid contents after treatment of approximately 800 m² reached equilibrium of 12.0% at maximum. In this case, by flowing the washing solution in the direction intersecting the traveling direction of the flexographic printing plate precursor, a consumption amount of the rinsing liquid could be reduced by half without the solid contents called residues being attached to the flexographic printing plate precursor, and a significant reduction of the waste liquid could be realized.

### [Example 4]

### (Example 20)

In example 1, in the washout processor 10 shown in Fig. 1, the imagewise exposed flexographic printing plate precursor described above was sunk into the washing solution in a state of being stuck to a support plate, and the support plate was moved eccentrically in a state of being pressed parallel to the brush, performing development treatment. During development treatment, the temperature of the washing solution was adjusted to a temperature of 50°C and was supplied to the developing tank. In addition, the first valve 20 (see Fig. 1) and the third valve 24 (see Fig. 1) were brought into an open state, the washing solution Q (see Fig. 1) that had passed through the filter 18 (see Fig. 1) was supplied from the supply port 15a (see Fig. 1) into the developing tank 12 via the blowout port 15b (see Fig. 1), the washing solution Q in the developing tank 12 was taken in from the output port 16a (see Fig. 1) via the suction port 16b (see Fig. 1) by the circulation pump 17 (see Fig. 1) and went via the filter 18 (see Fig. 1) and the heater 19 (see Fig. 1), and the washing solution Q was supplied into the developing tank 12. Accordingly, a flow of the washing solution Q from the side surface 12c of the developing tank 12 toward the side surface 12d was formed. In the flow of the washing solution Q from the side surface 12c toward the side surface 12d of the developing tank 12, the flow rate close to the suction port 16b of the side surface 12d was set to 100 cm/sec. The flow rate of the washing solution was measured using SI5007 manufactured by ifm efector Co., Ltd.

In addition, the second valve 22 (see Fig. 1) and the fourth valve 26 (see Fig. 1) were brought into an open state, the washing solution Q was flowed from the liquid feeding port 28 (see Fig. 1), and a flow of the washing solution Q toward the filter 29 (see Fig. 1), that is, a flow of the washing solution Q in the direction Fi (see Fig. 1) from the liquid feeding port 28 toward the filter 29 was formed. The direction Fi was a direction orthogonal to the traveling direction of the flexographic printing plate precursor 36. The liquid flow rate of the washing solution in the direction Fi was measured using SI5007 manufactured by ifm efector Co., Ltd.

In a case where the flexographic printing plate precursor was raised from the washing solution after development treatment was completed, the flow of the washing solution Q in the direction Fi was formed as described above.

In example 20, the liquid flow rate of the washing solution at the supply port was 70 cm/sec, and the liquid flow rate of the washing solution at the overflow port was 33 cm/sec.

### (Example 21)

Example 21 was different from example 20 in terms of the liquid flow rate of the washing solution, but other points were the same as in example 20.

In example 21, the liquid flow rate of the washing solution at the supply port was 150 cm/sec, and the liquid flow rate of the washing solution at the overflow port was 55 cm/sec.

### (Comparative Example 20)

Comparative example 20 was different from example 20 in that in a case where the flexographic printing plate precursor was raised from the washing solution after development treatment completion, a flow of the washing solution Q was not formed in the direction Fi as described above and in that the flow rate of a flow of the washing solution Q from the side surface 12c of the developing tank 12 toward the side surface 12d was 50 cm/sec, but other points were the same as in example 20.

### (Comparative Example 21)

Comparative example 21 was different from example 20 in that in a case where the flexographic printing plate precursor was raised from the washing solution after development treatment completion, a flow of the washing solution Q was not formed in the direction Fi as described above, but other points were the same as in example 20.

### (Comparative Example 22)

Comparative example 22 was different from example 20 in that in a case where the flexographic printing plate precursor was raised from the washing solution after development treatment completion, a flow of the washing solution Q was not formed in the direction Fi as described above and in that the flow rate of a flow of the washing solution Q from the side surface 12c of the developing tank 12 toward the side surface 12d was 200 cm/sec, but other points were the same as in example 20.

**[Table 3]**

| | Liquid flow rate of washing solution (cm/sec) | | Flow rate of washing solution close to suction port (cm/sec) | On-plate residues (piece/m²) |
|---|---|---|---|---|
| | Supply port | Overflow port | | |
| Example 20 | 70 | 33 | 100 | 6 |
| Example 21 | 150 | 55 | 100 | 0 |
| Comparative Example 20 | - | - | 50 | 18 |
| Comparative Example 21 | - | - | 100 | 9 |
| Comparative Example 22 | - | - | 200 | 8 |

In examples 20 and 21, in a case where the flexographic printing plate precursor was raised from the washing solution, the flow of the washing solution in the direction F₁ was formed as described above. Accordingly, floating substances, which were at the liquid level of the washing solution, were swept away, and solid contents were prevented from being attached to the flexographic printing plate precursor.

On the other hand, in comparative examples 20 to 22, in a case where the flexographic printing plate precursor was raised from the washing solution, the flow of the washing solution in the direction Fi was not formed as described above. For this reason, the solid contents were attached to the flexographic printing plate precursor.

### Explanation of References

10, 10a, 10b, 10c: washout processor
12: developing tank
12b: bottom surface
12c, 12d, 12e, 12f: side surface
13: lid
13b: back surface
14: brush
14a: substrate
14b: bristle
15a: supply port
15b: blowout port
16a: output port
16b: suction port
17, 68: circulation pump
18, 29: filter
19: heater
20: first valve
20b: fifth valve
21, 23, 25, 27: pipe
22: second valve
24: third valve
26: fourth valve
28: liquid feeding port
30: motor
32: crank
34: fixing member
35: support plate
36: flexographic printing plate precursor
36a: front surface
36b: back surface
36c: leading end
36d: trailing end
37: flow creation unit
38: development unit
40: development unit
41: brush
42: transport roller
43: connecting pipe
44: replenishment pump
45: replenishment tank
46: support body
47: rinsing unit
47a: rinsing liquid supply unit
47b: liquid drain nozzle
50: transporting unit
51: development unit
52: rinsing unit
52a: rinsing liquid supply unit
52b: liquid drain nozzle
52c: prerinsing nozzle
53: frame
53a: member
53b: beam member
54: developing tank
54b: bottom surface
54c, 54d: side surface
54g: space
55: gear
55a: shaft
56: transport chain
56b: fixing unit
57: transport driving unit
58: tension adjusting unit
59a, 59b: turn bar
60: back plate portion
61: brush
61a: rotation shaft portion
62: leading end leader
62a: base
62b: bending portion
62c: attaching portion
62d, 63d: pin
63: trailing end leader
63a: base
63b: bending portion
63c: attaching portion
64: leader mechanism portion
64a: frame material
64b: elastic member
65: waste liquid tank
65a: connecting pipe
66: supply port
66a, 66b: pipe
67: supply port
67a, 67b: pipe
69: tank
69a: partition plate
69b: overflow port
70: partition member
70a: end part
71: restricting member
80: pipe
80a: linear part
80b: bending part
82: block
83: heating heater
C: rotation axis
D: transport direction
Di: first region
D₂: second region
D_{L}: traveling direction
Di: carry-in direction
Dp: transport path
Dpc: transport passage
Dps: transport passage
Dw: direction
Fi: direction
LB: line of 90° (reference line)
Mb: swing width
Q: washing solution
Qs: liquid level
Qw: fatiqued developer
r: rotation direction
γ: nozzle angle
θ: angle

## Claims

1. A washout processor that develops an imagewise exposed flexographic printing plate precursor using a washing solution, the washout processor comprising:
a developing tank that is filled with the washing solution;
a development unit that performs the development by removing a non-exposed portion of the flexographic printing plate precursor using the washing solution in the developing tank; and
a flow creation unit that flows the washing solution in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

2. A washout processor that develops an imagewise exposed flexographic printing plate precursor using a washing solution, the washout processor comprising:
a developing tank that is filled with the washing solution;
a development unit that performs the development by removing a non-exposed portion of the flexographic printing plate precursor using the washing solution in the developing tank;
a transporting unit that carries the imagewise exposed flexographic printing plate precursor into the washing solution of the developing tank and that carries out the flexographic printing plate precursor after being developed by the development unit;
a rinsing unit that supplies a rinsing liquid to the developed flexographic printing plate precursor carried out from the development unit by the transporting unit; and
a flow creation unit that flows the washing solution in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

3. The washout processor according to claim 1 or 2,
wherein the flow creation unit flows the washing solution in the second region in the intersecting direction to cross the width of the flexographic printing plate precursor with respect to the traveling direction of the flexographic printing plate precursor.

4. The washout processor according to any one of claims 1 to 3,
wherein the intersecting direction to cross the width of the flexographic printing plate precursor with respect to the traveling direction of the flexographic printing plate precursor is a direction orthogonal to the traveling direction of the flexographic printing plate precursor.

5. The washout processor according to any one of claims 1 to 4,
wherein the first region and the second region are the same region.

6. The washout processor according to any one of claims 1 to 5,
wherein the flow creation unit flows the washing solution at a liquid flow rate of 50 cm/sec or more.

7. The washout processor according to claim 2,
wherein the developing tank has a first tank portion and a second tank portion with which the washing solution communicates, the flexographic printing plate precursor is carried in from the first tank portion, and the flexographic printing plate precursor after development is carried out from the second tank portion, and
the first region is in the first tank portion, and the second region is in the second tank portion.

8. The washout processor according to any one of claims 1 to 7, further comprising:
a filter that removes the non-exposed portion generated by the development from a collected washing solution; and
a supply unit that supplies a washing solution from which the non-exposed portion is removed by the filter to the developing tank.

9. The washout processor according to any one of claims 1 to 8,
wherein a restricting member that restricts a flow passage of the washing solution flowing in the intersecting direction to cross the width of the flexographic printing plate precursor is provided in at least one of the first region or the second region.

10. The washout processor according to any one of claims 1 to 9, further comprising:
a temperature adjusting device that adjusts a temperature of the washing solution,
wherein the temperature adjusting device has a heater, and
the heater includes a pipe, a block in which a part of the pipe is buried, and a heating heater provided in the block, and the block is formed of a metal material.

11. The washout processor according to claim 10,
wherein the heater further has a pump that causes the washing solution to pass through an inside of the pipe in the block at a liquid flow rate of 100 cm/sec or more.

12. A washing method of developing an imagewise exposed flexographic printing plate precursor using a washing solution, the washing method comprising:
a developing step of performing the development by removing a non-exposed portion of the flexographic printing plate precursor using the washing solution in a developing tank filled with the washing solution,
wherein the washing solution is flowed in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

13. A washing method of developing an imagewise exposed flexographic printing plate precursor using a washing solution, the washing method comprising:
a developing step of performing the development by removing a non-exposed portion of the flexographic printing plate precursor using the washing solution in a developing tank filled with the washing solution; and
a rinsing step of supplying a rinsing liquid to the developed flexographic printing plate precursor carried out from the developing tank,
wherein the washing solution is flowed in at least one region of a first region where the flexographic printing plate precursor is carried into the washing solution of the developing tank or a second region where the flexographic printing plate precursor is carried out from the washing solution of the developing tank, in an intersecting direction to cross a width of the flexographic printing plate precursor with respect to a traveling direction of the flexographic printing plate precursor.

14. The washing method according to claim 12 or 13,
wherein the washing solution is flowed in the second region in the intersecting direction to cross the width of the flexographic printing plate precursor with respect to the traveling direction of the flexographic printing plate precursor.

15. The washing method according to any one of claims 12 to 14,
wherein the intersecting direction to cross the width of the flexographic printing plate precursor with respect to the traveling direction of the flexographic printing plate precursor is a direction orthogonal to the traveling direction of the flexographic printing plate precursor.

16. The washing method according to any one of claims 12 to 15,
wherein the first region and the second region are the same region.

17. The washing method according to any one of claims 12 to 16,
wherein the washing solution is flowed at a liquid flow rate of 50 cm/sec or more.

18. The washing method according to any one of claims 12 to 17,
wherein the developing tank has a first tank portion and a second tank portion with which the washing solution communicates, the flexographic printing plate precursor is carried in from the first tank portion, and the flexographic printing plate precursor after development is carried out from the second tank portion, and
the first region is in the first tank portion, and the second region is in the second tank portion.

19. The washing method according to any one of claims 12 to 18,
wherein after the non-exposed portion generated by the development is removed from a collected washing solution,
the washing solution from which the non-exposed portion is removed by a filter is supplied to the developing tank.

20. The washing method according to any one of claims 12 to 19,
wherein a temperature of the washing solution is adjusted,
a heater is used in adjusting the temperature of the washing solution, and
the heater includes a pipe, a block in which a part of the pipe is buried, and a heating heater provided in the block, and the block is formed of a metal material.

21. The washing method according to claim 20,
wherein the washing solution is passed through an inside of the pipe in the block at a liquid flow rate of 100 cm/sec or more.
